(19) Europäisches Patentamt
European Patent Office
Office européen des brevets

(11) EP 4 435 072 A2

# (12) EUROPEAN PATENT APPLICATION

(43) Date of publication:
**25.09.2024 Bulletin 2024/39**

(21) Application number: **24165275.9**

(22) Date of filing: **21.03.2024**

(51) International Patent Classification (IPC):
***C09J 7/10*** *(2018.01)* ***C09J 133/08*** *(2006.01)*

(52) Cooperative Patent Classification (CPC):
(C-Sets available)
**C09J 7/10; C09J 133/08;** C09J 2203/318;
C09J 2203/326; C09J 2203/354; C09J 2301/312;
C09J 2433/00 (Cont.)

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **24.03.2023 KR 20230039207**
**20.07.2023 KR 20230094662**

(71) Applicant: **Samsung Display Co., Ltd.**
**Yongin-si, Gyeonggi-do 17113 (KR)**

(72) Inventors:
- **Lee, Joosub**
  **17113 Yongin-si (KR)**
- **Park, Youngju**
  **17113 Yongin-si (KR)**
- **Yoo, Seongsoo**
  **17113 Yongin-si (KR)**
- **Eun, Sangwon**
  **17113 Yongin-si (KR)**
- **Lee, Jinyoung**
  **17113 Yongin-si (KR)**

(74) Representative: **Crow, Martin et al**
**Venner Shipley LLP**
**200 Aldersgate**
**London EC1A 4HD (GB)**

## (54) ADHESIVE FILM, ELECTRONIC DEVICE COMPRISING THE SAME, AND VEHICLE COMPRISING THE ELECTRONIC DEVICE

(57) An adhesive film formed by curing a composition comprising a high-molecular-weight acrylic polymer having a weight average molecular weight of 700,000 or more, a low-molecular-weight acrylic polymer having a weight average molecular weight of less than 500,000, and a cross-linking agent, a photoinitiator, a molecular weight regulator, or a combination thereof is provided. Based on 100 parts by weight, which is a sum of an amount of the high-molecular-weight acrylic polymer and an amount of the low-molecular-weight acrylic polymer, the amount of the high-molecular-weight acrylic polymer is 30 parts by weight or more, and the adhesive film has a degree of stress relaxation of 0.01 to 0.50, a creep at 50 °C of 4% or more, and a modulus at 25 °C of 0.04 MPa to 0.70 MPa.



Processed by Luminess, 75001 PARIS (FR)

(Cont. next page)

(52) Cooperative Patent Classification (CPC): (Cont.)

C-Sets
C09J 2433/00, C09J 2433/00

## Description

### CROSS-REFERENCES TO RELATED APPLICATION

This application claims priority to and the benefit of Korean Patent Application No. 1 0-2023-0039207, filed on March 24, 2023, and Korean Patent Application No. 1 0-2023-0094662, filed on July 20, 2023, in the Korean Intellectual Property Office, the entire disclosure of each of which is incorporated by reference herein.

### BACKGROUND

#### 1. Field

One or more embodiments of the present disclosure relate to an adhesive film, an electronic device comprising the same, and a vehicle comprising the electronic device.

#### 2. Description of the Related Art

Implementation of an electronic device (e.g., display device) requires (or there is a desire for) an adhesive film polymer having improved reliability of optical properties and/or adhesive properties. For example, in a high-temperature environment and/or a high-temperature and high-humidity environment, the flow properties of the adhesive film polymer may be degraded or otherwise modified. As a result, the reliability of optical properties and/or adhesive properties of the adhesive film may be deteriorated. Therefore, the need or desire exists for the development of materials for an adhesive film polymer capable of stably attaining such characteristics.

An electronic device comprising a light-emitting element may comprise a display panel emitting light, a cover window protecting the display panel, and an adhesive film provided between the display panel and the cover window. The adhesive film may have optical properties to allow light to be emitted and may have adhesive properties to prevent or reduce separation of the display panel and the cover window from each other.

### SUMMARY

One or more aspects of embodiments of the present disclosure directed toward an adhesive film having improved flow characteristics and excellent or suitable reliability in a high temperature environment and/or a high temperature and high humidity environment, an electronic device comprising the adhesive film, and a vehicle comprising the electronic device.

Additional aspects will be set forth in part in the description which follows and, in part, will be apparent from the description, or may be learned by practice of the presented embodiments of the disclosure.

One or more embodiments comprise an adhesive film which is formed by first-curing a composition that comprises

a high-molecular weight acrylic polymer having a first weight average molecular weight of 700,000 or more,
a low-molecular weight acrylic polymer having a second weight average molecular weight of not more (e.g., less than) 500,000, and
a cross-linking agent, a photoinitiator, a molecular weight regulator, or a combination thereof,
wherein,
based on 100 parts by weight, which is the sum of the amount of the high-molecular weight acrylic polymer and the amount of the low-molecular weight acrylic polymer, the amount of the high-molecular weight acrylic polymer is 30 parts by weight or more.

One or more embodiments comprise an adhesive film which is formed by curing a composition that comprises

an acrylic polymer, and
a cross-linking agent, a photoinitiator, a molecular weight regulator, or a combination thereof,
wherein
a degree of stress relaxation of the adhesive film calculated according to Equation 1 is from about 0.20 to about 0.70,
a creep of the adhesive film at 50 °C is 4% or more, and
a modulus of the adhesive film at 25 °C is about 0.04 MPa to about 0.70 MPa:

Equation 1

$$SR = ST_{300}/ST_{0.01}$$

wherein, in Equation 1,
SR is the degree of stress relaxation,
$ST_{300}$ is the value of stress when a strain of 25% is applied for 300 seconds, and
$ST_{0.01}$ is the value of stress when a strain of 25% is applied for 0.01 seconds.

According to one or more embodiments, an electronic device comprises

a display panel comprising a light-emitting element,
a cover window provided on the display panel,
a first adhesive film and/or a second adhesive film provided between the display panel and the cover window, and
a color filter, a color conversion layer, a touch screen layer, a polarization layer, or a combination thereof.

According to one or more embodiments, a vehicle comprises

a body,
a chassis, and
an electronic device, wherein
the electronic device comprises a display panel comprising a light-emitting element, a cover window provided on the display panel, and an adhesive film provided between the display panel and the cover window, wherein
the adhesive film is formed by first-curing a composition comprising
a high-molecular weight acrylic polymer having a first weight average molecular weight of 700,000 or more,
a low-molecular weight acrylic polymer having a second weight average molecular weight of at most (e.g., less than) 500,000, and
a cross-linking agent, a photoinitiator, a molecular weight regulator, or a combination thereof,
wherein,
based on 100 parts by weight, which is the sum of the amount of the high-molecular weight acrylic polymer and the amount of the low-molecular weight acrylic polymer, the amount of the high-molecular weight acrylic polymer is 30 parts by weight or more.

According to one or more embodiments, a vehicle comprises

a body,
a chassis, and
an electronic device, wherein
the electronic device comprises a display panel comprising a light-emitting element, a cover window provided on the display panel, and an adhesive film provided between the display panel and the cover window, wherein
the adhesive film is formed by first-curing a composition comprising
an acrylic polymer, and
a cross-linking agent, a photoinitiator, a molecular weight regulator, or a combination thereof,
wherein
the degree of stress relaxation of the adhesive film calculated according to Equation 1 is from about 0.20 to about 0.70,
a creep of the adhesive film at 50 °C is 4% or more, and
a modulus of the adhesive film at 25 °C is about 0.04 MPa to about 0.70 MPa:

Equation 1

$$SR = ST_{300}/ST_{0.01}$$

wherein, in Equation 1,
SR is the degree of stress relaxation,
$ST_{300}$ is the value of stress when a strain of 25% is applied for 300 seconds, and
$ST_{0.01}$ is the value of stress when a strain of 25% is applied for 0.01 seconds.

## BRIEF DESCRIPTION OF THE DRAWINGS

The accompanying drawings are included to provide a further understanding of the present disclosure, and are incorporated in and constitute a part of this specification. The drawings illustrate example embodiments of the present disclosure and, together with the description, serve to explain principles of the present disclosure. In the drawings:

FIG. 1 shows a diagram schematically illustrating an electronic device according to one or more embodiments of the present disclosure;
FIG. 2 shows a perspective view schematically illustrating an electronic apparatus comprising an electronic device according to one or more embodiments of the present disclosure;
FIG. 3 shows a diagram schematically showing the exterior of a vehicle as an electronic apparatus comprising an electronic device according to one or more embodiments of the present disclosure;
FIGS. 4A-4C show diagrams schematically illustrating the interior of the vehicle of FIG. 3;
FIG. 5 shows a diagram showing the adhesive strength of adhesive films according to one or more embodiments of the present disclosure;
FIG. 6 shows a diagram showing the adhesive strength of adhesive films according to one or more embodiments of the present disclosure;
FIGS. 7A-7E show diagrams of reliability evaluation of an electronic device comprising adhesive films utilizing scanning acoustic microscopy (SAM) according to one or more embodiments of the present disclosure; and
FIGS. 8A-8F show diagrams of reliability evaluation of an electronic device comprising adhesive films utilizing SAM according to one or more embodiments of the present disclosure.

## DETAILED DESCRIPTION

Reference will now be made in more detail to embodiments, examples of which are illustrated in the accompanying drawings, wherein like reference numerals refer to like elements throughout, and duplicative descriptions thereof may not be provided. In this regard, the present embodiments may have different forms and should not be construed as being limited to the descriptions set forth herein but rather, is intended to cover all modifications, equivalents, and alternatives falling within the spirit and scope of the present disclosure. Accordingly, the embodiments are merely described, by referring to the drawings, to explain aspects of the present description.
When explaining each of drawings, like reference numbers are utilized for referring to like elements. In the accompanying drawings, the dimensions of each structure are exaggeratingly illustrated for clarity of the present disclosure. It will be understood that, although the terms "first," "second," and/or the like, may be utilized herein to describe one or more suitable components, these components should not be limited by these terms. These terms are only utilized to distinguish one component from another. For example, a first component could be termed a second component, and, similarly, a second component could be termed a first component, without departing from the scope of example embodiments of the present disclosure.
As utilized herein, the singular forms, "a," "an," and "the" are intended to include the plural forms as well, unless the context clearly indicates otherwise.
As utilized herein, the terms "use," "using," and "used" may be considered synonymous with the terms "utilize," "utilizing," and "utilized," respectively.
As utilized herein, the term "and/or" includes any and all combinations of one or more of the associated listed items.
As utilized herein, expressions such as "at least one of," "one of," "selected from," and "selected from among," when preceding a list of elements, modify the entire list of elements and do not modify the individual elements of the list. For example, the expressions "at least one of a to c," "at least one of a, b or c," and "at least one of a, b and/or c" may indicate only a, only b, only c, both (e.g., simultaneously) a and b, both (e.g., simultaneously) a and c, both (e.g., simultaneously) b and c, all of a, b, and c, or variations thereof.
In the present application, it will be understood that the terms "include," "includes," "including," "comprise," "comprises", "comprising," "have," "has," "having," and/or the like when utilized in this specification, specify the presence of features, numbers, steps, operations, component, parts, or combinations thereof disclosed in the specification, but do not exclude the possibility of presence or addition of one or more other features, numbers, steps, operations, component, parts, or combinations thereof.
In the present application, when a layer, a film, a region, or a plate is referred to as being "on" or "in an upper portion of' another layer, film, region, or plate, it may be not only "directly on" the layer, film, region, or plate, but intervening layers, films, regions, or plates may also be present. On the contrary to this, when a layer, a film, a region, or a plate is referred to as being "in a lower portion of" another layer, film, region, or plate, it can be not only directly under the layer, film, region, or plate, but intervening layers, films, regions, or plates may also be present. In some embodiments, it will

be understood that when a part is referred to as being "on" another part, it can be provided above the other part, or provided under the other part as well. The terms such as "lower", "above", "upper," and/or the like, may be utilized herein for the description to describe one element's relationship to another element illustrated in the drawings. It will be understood that the terms have a relative concept and are described on the basis of the orientation depicted in the drawings. It will be understood that the spatially relative terms are intended to encompass different orientations of the device in use or operation in addition to the orientation depicted in the drawings. For example, if the device in the drawings is turned over, elements described as "beneath" other elements or features would then be oriented "above" or "over" the other elements or features. Thus, the term "beneath" may encompass both an orientation of above and below. The device may be otherwise oriented (rotated 90 degrees or at other orientations), and the spatially relative descriptors used herein should be interpreted accordingly.

As utilized herein, the term "may" will be understood to refer to "one or more embodiments of the present disclosure," some of which comprise the described element and some of which exclude that element and/or comprise an alternate element. Similarly, alternative language such as "or" refers to "one or more embodiments of the present disclosure," each comprising a corresponding listed item.

As utilized herein, all terms (including chemical, technical and scientific terms), unless otherwise defined, have the same meaning as commonly understood by one of ordinary skill in the art to which the present disclosure belongs. Also, terms, such as those defined in commonly utilized dictionaries, should be interpreted as having a meaning that is consistent with their meaning in the context of the relevant art and should not be interpreted in an idealized or overly formal sense unless expressly so defined herein.

As utilized herein, the phrase "consisting essentially of" means that any additional components will not materially affect the chemical, physical, optical, or electrical properties of the semiconductor film.

As utilized herein, the phrase "on a plane," or "plan view," refers to viewing a target portion from the top, and the phrase "on a cross-section" means viewing a cross-section formed by vertically cutting a target portion from the side.

Hereinafter, embodiments of the present disclosure will be described with reference to the accompanying drawings.

**Description of FIG. 1**

FIG. 1 shows a diagram schematically illustrating an electronic device 10 according to one or more embodiments.

Referring to FIG. 1, the electronic device 10 may comprise a display panel 100, a polarization layer 200, an adhesive film 300, a black matrix 400, and a cover window 500. The electronic device 10 may be a display device, an authentication device, and/or the like. The electronic device 10 may further comprise a color filter, a color conversion layer, a touch screen layer, or a combination thereof. The color filter and/or the color conversion layer may be provided on at least one traveling direction of light emitted from the light-emitting element. For example, light emitted from the light-emitting element may be blue light or white light. The color conversion layer may comprise quantum dots.

The display panel 100 may comprise a light-emitting element and a thin film transistor electrically connected to the light-emitting element. The light-emitting element may be to emit (e.g., configured to emit) light. The light-emitting element may be an inorganic light-emitting element or an organic light-emitting element. The thin film transistor may be to transmit (e.g., configured to transmit) a driving signal so that the light-emitting element emits light.

The polarization layer 200 may be provided on the display panel 100. The polarization layer 200 may polarize light emitted from the display panel 100.

The cover window 500 may be provided on the display panel 100. The cover window 500 may protect the display panel 100 from impact, moisture, impurities, and/or the like.

The black matrix 400 may be provided on one surface of the cover window 500. The black matrix 400 may be provided between the display panel 100 and the cover window 500. The black matrix 400 may prevent or reduce light emitted from the display panel 100 from being transmitted.

The adhesive film 300 may be provided between the display panel 100 and the cover window 500. According to one or more embodiments, the adhesive film 300 may be provided between the polarization layer 200 and the black matrix 400. The adhesive film 300 may have appropriate or suitable optical properties so that the luminance, luminous efficiency, and viewing angle of light emitted from the electronic device 10 are appropriate or suitable. For example, the adhesive film 300 may be transparent to allow light to pass therethrough. The adhesive film 300 may have appropriate or suitable adhesive properties so that components in contact with each other are not separated. In order to have the optical properties and the adhesive properties, the adhesive film 300 may comprise a polymer.

The adhesive film 300 may be referred to as an optical clear adhesive (OCA) or may be a pressure sensitive adhesive (PSA).

A step may occur between one area where the adhesive film 300 and the black matrix 400 overlap and another area where the adhesive film 300 and the black matrix 400 do not overlap. Due to the step difference, the adhesive film 300 may expose (e.g., not cover) the black matrix 400, and in this case, the adhesive film 300 and the black matrix 400

may be separated from each other. Therefore, the adhesive film 300 needs to have appropriate or suitable flexibility so as to cover the black matrix 400 completely (e.g., even at the step difference or at the step).

As utilized herein, the term "creep" is a phenomenon in which strain is increased according to stress when a certain stress is applied for a certain time at a specific temperature. In some embodiments, creep may be a criterion for determining a degree of flexibility. For example, the less (e.g., smaller) the creep, the less (e.g., lower) the flexibility, so the adhesive film 300 may expose (e.g., not cover) the black matrix 400. Therefore, the adhesive film 300 needs to have an appropriate or suitable level of creep.

An adhesive film, referred to as an optical clear adhesive (OCA), may be prepared by curing a monomer solution utilizing ultraviolet rays (hereinafter referred to as ultraviolet (UV) curing) and coating the monomer solution. The OCA may be classified into a UV curing type or kind (e.g., UV curable or non-cured) OCA, a UV non-curing type or kind (e.g., UV non-curable or cured) OCA, and/or the like.

For example, in the case of a UV curable OCA, a monomer solution is first UV cured (e.g., to provide the (intermediate) UV curable OCA, and the display panel 100, the polarization layer 200, the first UV cured film, and the cover window 500 are bonded (a lamination module process). In addition, the first UV cured film may then be second UV cured to produce the adhesive film 300. Because the first UV cured film has a low crosslinking density and has a relatively soft property, the first UV cured film may appropriately or suitably cover the step of the black matrix 400. Accordingly, even when the first UV cured film would (later) have a hard characteristic due to the second UV curing, the UV curable OCA(e.g., first UV cured film) may lighten the weight of the electronic device 10 by having a relatively small thickness. However, the second UV curing process that proceeds or occurs after the lamination module process may cause an increase in process costs and process time.

In some embodiments, a UV uncured OCA may be manufactured into the adhesive film 300 (e.g., bonded with the display panel 100, the polarization layer 200, and the cover window 500) then followed by sufficiently or suitably proceeding with the first UV curing (e.g., increasing the extent of the first UV curing). For example, in the case of the UV uncured OCA, the second UV curing process does not proceed (or need to occur) after the lamination module process, resulting in a decrease in process costs and process time (e.g., by not needing the second UV curing process). However, the UV uncured OCA may have low creep. Accordingly, the step of the black matrix 400 may not be properly addressed (e.g., covered) and in response, the UV uncured OCA needs to be manufactured to have a relatively large thickness. Here, due to the relatively thick UV uncured OCA, the weight of the electronic device 10 may be increased.

The UV non-curable (i.e., cured) OCA that is produced after the second UV curing may have properties (e.g., degree of stress relaxation creep, modulus, adhesive strength) similar to those of the non-UV cured OCA.

In a high-temperature environment, a portion of the polymer comprised in the adhesive film may be deformed due to flow characteristics. The flow characteristics of the polymer may be accelerated in a high temperature and high humidity environment. Due to the flow and deformation of the polymer, bubbles may be generated or peeling may occur at the interface. Once the bubbles and/or exfoliation occurs, the adhesive film 300 may not have appropriate or suitable optical characteristics and/or appropriate or suitable adhesive characteristics. Therefore, the adhesive film 300 needs to have excellent or suitable reliability even in a high temperature environment and/or a high temperature and high humidity environment.

The degree of stress relaxation may be measured utilizing a stress relaxation method and may be a criterion for determining the crosslinking density of the polymer comprised in the adhesive film. As the crosslinking density is increased, the flow properties of polymers in a high-temperature environment may be suppressed or reduced (or prevented) due to physical and/or chemical interactions between polymers, and the undesired acceleration of the flow properties may be suppressed or reduced (or prevented) even in a high-temperature, high-humidity environment.

**First Adhesive Film**

According to one aspect, provided is a first adhesive film which may be formed by first curing a composition (e.g., to provide a first-cured adhesive film). The composition may comprise:

a high-molecular weight acrylic polymer having a first weight average molecular weight of about 700,000 or greater;
a low-molecular weight acrylic polymer having a second weight average molecular weight of less than about 500,000; and
a cross-linking agent, a photoinitiator, a molecular weight regulator, or a combination thereof,
wherein,
based on 100 parts by weight, which is the sum of an amount (e.g., content) of the high-molecular weight acrylic polymer and an amount (e.g., content) of the low-molecular weight acrylic polymer, the amount of the high-molecular weight acrylic polymer may be about 30 parts by weight or more.

The first adhesive film may be a UV curable OCA.

The weight average molecular weight may be measured utilizing a gel permeation chromatography (GPC) method.

According to one or more embodiments, based on 100 parts by weight, which is the sum of the amount of the high-molecular weight acrylic polymer and the amount of the low-molecular weight acrylic polymer, the amount of the high-molecular weight acrylic polymer is about 30 parts by weight to about 99 parts by weight, about 30 parts by weight to about 95 parts by weight, about 30 parts by weight to about 90 parts by weight, about 30 parts by weight to about 85 parts by weight, about 30 parts by weight to about 80 parts by weight, about 30 parts by weight to about 75 parts by weight, about 30 parts by weight to about 70 parts by weight, about 30 parts by weight to about 65 parts by weight, about 30 parts by weight to about 60 parts by weight, about 30 parts by weight to about 55 parts by weight, about 30 parts by weight to about 50 parts by weight, about 30 parts by weight to about 45 parts by weight, about 30 parts by weight to about 40 parts by weight, or about 30 parts by weight to about 35 parts by weight.

According to one or more embodiments, the first adhesive film may have

a degree of stress relaxation calculated according to Equation 1 of about 0.01 to about 0.50,
a creep at about 50 °C of about 4% or more,
a modulus at 25 °C of between about 0.04 megapascal (MPa) and about 0.70 MPa:

Equation 1

$$SR = ST_{300}/ST_{0.01}$$

wherein, in Equation 1,
SR is the degree of stress relaxation,
$ST_{300}$ is the value of stress when a strain of 25% is applied for 300 seconds, and
$ST_{0.01}$ is the value of stress when a strain of 25% is applied for 0.01 seconds.

According to one or more embodiments, each of $ST_{300}$ and $ST_{0.01}$ in Equation 1 may be measured at about 70 °C. For example, the degree of stress relaxation may be measured at about 70 °C.

According to one or more embodiments, the degree of stress relaxation of the first adhesive film (e.g., formed by the first curing of the composition) may be

about 0.01 to about 0.40, about 0.01 to about 0.30, about 0.01 to about 0.20, about 0.01 to about 0.12, about 0.01 to about 0.11, about 0.01 to about 0.10, about 0.01 to about 0.09, about 0.01 to about 0.08, about 0.01 to about 0.05, about 0.02 to about 0.40, about 0.02 to about 0.30, about 0.02 to about 0.20, about 0.02 to about 0.12, about 0.02 to about 0.11, about 0.02 to about 0.10, about 0.02 to about 0.09, about 0.02 to about 0.08, about 0.02 to about 0.05, or about 0.03 to about 0.40, about 0.03 to about 0.30, about 0.03 to about 0.20, about 0.03 to about 0.15, about 0.03 to about 0.12, about 0.03 to about 0.11, about 0.03 to about 0.10, about 0.03 to about 0.09, about 0.03 to about 0.08, or about 0.03 to about 0.05.

According to one or more embodiments, the first adhesive film may then be second-cured to provide a second-cured first adhesive film, and after the second curing of the first adhesive film, the degree of stress relaxation of the adhesive film (i.e., second-cured first adhesive film) may be about 0.20 to about 0.70. The second curing may proceed by irradiating the first adhesive film with ultraviolet light at a light amount of about 500 mJ to about 1500 mJ.

For example, the degree of stress relaxation of the second-cured first adhesive film may be

about 0.20 to about 0.65, about 0.20 to about 0.60, about 0.20 to about 0.55, about 0.20 to about 0.50, about 0.20 to about 0.45, about 0.20 to about 0.40, about 0.20 to about 0.35, about 0.20 to about 0.30, about 0.20 to about 0.25, or about 0.25 to about 0.65, about 0.25 to about 0.60, about 0.25 to about 0.55, about 0.25 to about 0.50, about 0.25 to about 0.45, about 0.25 to about 0.40, about 0.25 to about 0.35, or about 0.25 to about 0.30.

According to one or more embodiments, the degree of stress relaxation of the second-cured adhesive film (e.g., formed by the second curing of the first adhesive film) may be greater than that (i.e., degree of stress relaxation) of the first-cured adhesive film which does not undergo the second curing (e.g., formed just by the first curing of the composition). For example, the amount of change in the degree of stress relaxation calculated according to Equation 2 may be about 50% to about 600%, or about 70% to about 560%:

Equation 2

$$\triangle SR = [(SR_2 - SR_1)/SR_1] \times 100$$

wherein, in Equation 2,

$\Delta SR$ is the change in stress relaxation,
SR, is the degree of stress relaxation of the first adhesive film which does not undergo the second curing,
SRz is the degree of stress relaxation of the second-cured first adhesive film.

According to one or more embodiments, the creep of the first adhesive film at about 50 °C (e.g., on which the second curing is not performed) may be

about 5% to about 100%, about 6% to about 90%, about 7% to about 80%, about 8% to about 70%, about 9% to about 60%, about 10% to about 50%, or about 15% to about 40%,
about 10% to about 90%, about 10% to about 80%, about 10% to about 70%, about 10% to about 60%, about 10% to about 50%, or about 10% to about 40%,
about 20% to about 90%, about 20% to about 80%, about 20% to about 70%, about 20% to about 60%, or about 20% to about 50%, or
about 30% to about 90%, about 30% to about 80%, about 30% to about 70%, about 30% to about 60%, about 30% to about 50%, about 30% to about 40%, about 30% to about 39%, about 33% to about 38%, or about 34% to about 38%.

According to one or more embodiments, the creep of the second-cured first adhesive film at about 50 °C may be

about 4% to about 100%, about 5% to about 90%, about 6% to about 80%, about 7% to about 70%, about 8% to about 60%, about 9% to about 50%, about 10% to about 40%,
about 5% to about 20%, about 5% to about 19%, about 5% to about 18%, about 5% to about 17%, about 5% to about 16%, about 5% to about 15%, about 5% to about 14%, about 5% to about 13%, about 5% to about 12%, about 5% to about 11%, or about 5% to about 10%, or
about 6% to about 14%, about 7% to about 13%, about 8% to about 12%, or about 9% to about 11%.

According to one or more embodiments, the modulus of the first adhesive film after the first curing (e.g., on which the second curing does not proceed or has not ocurred) may be about 0.04 MPa to about 0.60 MPa, about 0.04 MPa to about 0.50 MPa, about 0.04 MPa to about 0.40 MPa, about 0.04 MPa to about 0.30 MPa, about 0.04 MPa to about 0.20 MPa, about 0.08 MPa to about 0.60 MPa, about 0.08 MPa to about 0.50 MPa, about 0.08 MPa to about 0.40 MPa, about 0.12 MPa to about 0.40 MPa, or about 0.12 MPa to about 0.30 MPa.

According to one or more embodiments, the second cured first adhesive film has a modulus of about 0.04 MPa to about 0.70 MPa, about 0.08 MPa to about 0.60 MPa, about 0.12 MPa to about 0.50 MPa, about 0.15 MPa to about 0.40 MPa, about 0.18 MPa to about 0.30 MPa, or about 0.20 MPa.

The modulus may be indicated as a modulus value at room temperature (25 °C), which is an actual-utilization temperature, after measuring the modulus for each temperature through a rheometer.

According to one or more embodiments, the first weight average molecular weight may be about 700,000 to about 3,000,000. For example, the first weight average molecular weight may be about 700,000 to about 1,500,000 or about 700,000 to about 1,000,000.

According to one or more embodiments, the second weight average molecular weight may be about 50,000 to about 490,000. For example, the second weight average molecular weight may be about 70,000 to about 400,000, or about 100,000 to about 300,000.

According to one or more embodiments, the adhesive strength of the first adhesive film may be about 300 gram force per 28 millimeter (gf/28 mm) or more. The adhesive strength may be an average value calculated by measuring the adhesive strength of the first adhesive film several (e.g., a plurality of) times. For example, the adhesive strength of the first adhesive film may be about 500 gf/28mm or more, about 600 gf/28mm or more, about 700 gf/28mm or more, about 800 gf/28mm or more, about 900 gf/28mm to about 1500 gf/28mm, about 910 gf/28mm to about 1400 gf/28mm, or about 920 gf/28mm to about 1300 gf/28mm.

According to one or more embodiments, at least one of the high-molecular weight acrylic polymer and the low-molecular weight acrylic polymer may exclude (e.g., not comprise or contain) silicon element (Si). For example, the high-molecular weight acrylic polymer may exclude (e.g., not comprise or contain) silicon, and the low-molecular weight acrylic

polymer may exclude (e.g., not comprise or contain) silicon. In present disclosure, "not include (including) a or any 'component'" "exclude (excluding) a or any 'component'", "'component'-free", and/or the like refers to that the "component" not being added, selected or utilized as a component in the composition, but the "component" of less than a suitable amount may still be included due to other impurities and/or external factors.

According to one or more embodiments, each of the high-molecular weight acrylic polymer and the low-molecular weight acrylic polymer is a polymer of a first compound represented by Formula 1 and a second compound represented by Formula 2, wherein the first compound and the second compound may be different from each other:

Formula 1

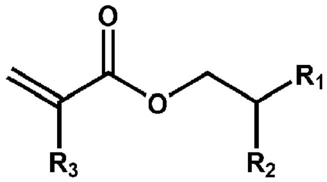

Formula 2

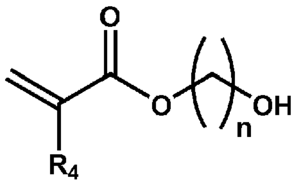

wherein, in Formulae 1 and 2,

$R_1$ to $R_4$ may each independently be hydrogen, deuterium, a hydroxyl group, or a $C_1$-$C_{10}$ alkyl group, and
n may be an integer from 1 to 10.

For example, $R_1$ may be a butyl group, $R_2$ may be an ethyl group, $R_3$ may be hydrogen, R4 may be hydrogen, and n may be 2.

According to one or more embodiments, each of the high-molecular weight acrylic polymer and the low-molecular weight acrylic polymer may be a polymer of 2-ethylhexyl acrylate and 2-hydroxyethyl acrylate.

In one or more embodiments, when the high-molecular weight acrylic polymer is a polymer of the first compound and the second compound, the amount of the first compound may be about 75 parts by weight to about 85 parts by weight, and the amount of the second compound may be about 15 parts by weight to about 25 parts by weight, based on 100 parts by weight of the total weight of the high-molecular weight acrylic polymer.

In one or more embodiments, when the low-molecular weight acrylic polymer is a polymer of the first compound and the second compound, the amount of the first compound may be about 75 parts by weight to about 85 parts by weight, and the amount of the second compound may be about 15 parts by weight to about 25 parts by weight, based on 100 parts by weight of the total weight of the low-molecular weight acrylic polymer.

According to one or more embodiments, the cross-linking agent may be represented by Formula 3:

Formula 3

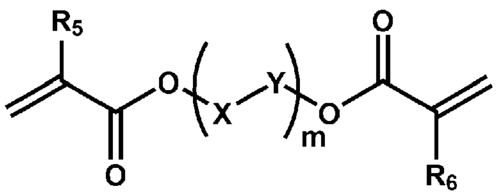

wherein, in Formula 3,

X and Y may each independently be $CH_2$ or O;
$R_5$ and $R_6$ may each independently be hydrogen, deuterium, a hydroxyl group or a $C_1$-$C_{10}$ alkyl group;
m may be an integer from 1 to 10;

For example, each of $R_5$ and $R_6$ may be hydrogen; i) X and Y may each be $CH_2$ or ii) X may be $CH_2$, and Y may be O; and m may be an integer from 3 to 6.

According to one or more embodiments, the cross-linking agent may be 1,6-hexanediol diacrylate or polyethylene glycol) diacrylate.

According to one or more embodiments, the first adhesive film may further comprise the cross-linking agent, and the amount of the cross-linking agent may be about 0.01 parts by weight to about 0.5 parts by weight based on 100 parts by weight, which is the sum of the amount of the high-molecular weight acrylic polymer and the amount of the low-molecular weight acrylic polymer.

According to one or more embodiments, the photoinitiator may be (1-hydroxycyclohexyl)(phenyl)methanone.

According to one or more embodiments, the first adhesive film may further comprise the photoinitiator, and the amount of the photoinitiator may be about 0.01 parts by weight to about 0.4 parts by weight based on 100 parts by weight, which is the sum of the amount of the high-molecular weight acrylic polymer and the amount of the low-molecular weight acrylic polymer.

According to one or more embodiments, the molecular weight regulator may be n-dodecyl mercaptan.

According to one or more embodiments, the first adhesive film may further comprise the molecular weight regulator, and the amount of the molecular weight regulator may be 0.01 parts by weight to about 0.2 parts by weight based on 100 parts by weight, which is the sum of the amount of the high-molecular weight acrylic polymer and the amount of the low-molecular weight acrylic polymer.

According to one or more embodiments, the first adhesive film may be an optical clear adhesive (OCA). For example, the first adhesive film may be transparent.

**Second Adhesive Film**

According to another aspect, provided is a second adhesive film which may be formed by curing (e.g., first curing and/or second curing) a composition comprising

an acrylic polymer, and
a cross-linking agent, a photoinitiator, a molecular weight regulator, or a combination thereof,
wherein
the degree of stress relaxation thereof calculated according to Equation 1 may be from about 0.20 to about 0.70,
the creep thereof at about 50 °C may be about 4% or more,
a modulus thereof at 25 °C may be about 0.04 MPa to about 0.70 MPa:

Equation 1

$$SR = ST_{300}/ST_{0.01}$$

wherein, in Equation 1,
SR is the degree of stress relaxation,
$ST_{300}$ is the value of stress when a strain of 25% is applied for 300 seconds, and
$ST_{0.01}$ is the value of stress when a strain of 25% is applied for 0.01 seconds.

The second adhesive film may be a UV uncured OCA.

According to one or more embodiments, the acrylic polymer may have a weight average molecular weight of about 100,000 to about 3,000,000. For example, the weight average molecular weight of the acrylic polymer may be about 700,000 to about 3,000,000, about 700,000 to about 1,500,000 or about 700,000 to about 1,000,000, about 100,000 to about 690,000, about 100,000 to about 600,000, about 100,000 to about 550,000, about 100,000 to about 530,000, about 110,000 to about 600,000, about 110,000 to about 550,000 or about 110,000 to about 530,000.

According to one or more embodiments, each of $ST_{300}$ and $ST_{0.01}$ in Equation 1 may be measured at about 70 °C For example, the degree of stress relaxation may be measured at about 70 °C

According to one or more embodiments, the degree of stress relaxation of the second adhesive film may be about 0.20 to about 0.65, about 0.20 to about 0.60, about 0.20 to about 0.55, about 0.20 to about 0.50, about 0.20 to about 0.45, about 0.20 to about 0.40, about 0.20 to about 0.35, about 0.20 to about 0.30, about 0.20 to about 0.25, or about 0.25 to about 0.65, about 0.25 to about 0.60, about 0.25 to about 0.55, about 0.25 to about 0.50, about 0.25 to about 0.45, about 0.25 to about 0.40, about 0.25 to about 0.35, or about 0.25 to about 0.30.

According to one or more embodiments, the creep of the second adhesive film at about 50 °C may be

about 4% to about 100%, about 5% to about 90%, about 6% to about 80%, about 7% to about 70%, about 8% to about 60%, about 9% to about 50%, about 10% to about 40%,

about 5% to about 20%, about 5% to about 19%, about 5% to about 18%, about 5% to about 17%, about 5% to about 16%, about 5% to about 15%, about 5% to about 14%, about 5% to about 13%, about 5% to about 12%, about 5% to about 11%, or about 5% to about 10%, or

about 6% to about 14%, about 7% to about 13%, about 8% to about 12%, or about 9% to about 11%.

According to one or more embodiments, the modulus of the second adhesive film may be about 0.04 MPa to about 0.70 MPa, about 0.08 MPa to about 0.60 MPa, about 0.12 MPa to about 0.50 MPa, about 0.15 MPa to about 0.40 MPa, about 0.18 MPa to about 0.30 MPa, or about 0.20 MPa

The modulus may be indicated as a modulus value at room temperature (25 °C), which is an actual-utilization temperature, after measuring the modulus for each temperature through a rheometer.

According to one or more embodiments, the adhesive strength of the second adhesive film may be about 300 gf/28 mm or more. The adhesive strength may be an average value calculated by measuring the adhesive strength of the second adhesive film several (e.g., a plurality of) times. For example, the adhesive strength of the second adhesive film may be about 310 gf/28mm or more, about 320 gf/28mm or more, about 300 gf/28mm to about 500 gf/28mm, about 310 gf/28mm to about 400 gf/28mm, or about 320 gf/28mm to about 390 gf/28mm.

According to one or more embodiments, the acrylic polymer may exclude (e.g., not comprise or contain) silicon element (Si).

According to one or more embodiments, the second adhesive film may be formed by curing with ultraviolet (UV) light at an amount of about 500 mJ to about 1500 mJ.

According to one or more embodiments, the acrylic polymer may be a polymer of a first compound represented by Formula 1 and a second compound represented by Formula 2, and the first compound and the second compound may be different from each other:

Formula 1

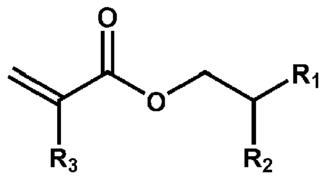

Formula 2

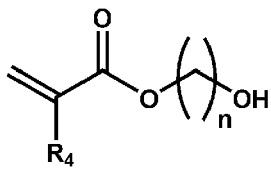

wherein, in Formulae 1 and 2,

$R_1$ to $R_4$ may each independently be hydrogen, deuterium, a hydroxyl group, or a $C_1$-$C_{10}$ alkyl group, and

n may be an integer from 1 to 10.

For example, $R_1$ may be a butyl group, $R_2$ may be an ethyl group, $R_3$ may be hydrogen, R4 may be hydrogen, and n may be 2.

According to one or more embodiments, the acrylic polymer may be a polymer of 2-ethylhexyl acrylate and 2-hydroxyethyl acrylate.

According to one or more embodiments, with respect to the total of 100 parts by weight of the acrylic polymer, the amount of the first compound may be about 75 parts by weight to about 85 parts by weight, and the amount of the second compound is about 15 parts by weight to about 25 parts by weight.

According to one or more embodiments, the cross-linking agent may be represented by Formula 3:

Formula 3

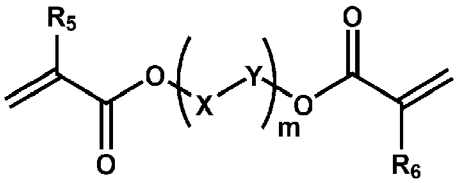

wherein, in Formula 3,

X and Y may each independently be $CH_2$ or O;
$R_5$ and $R_6$ may each independently be hydrogen, deuterium, a hydroxyl group or a $C_1$-$C_{10}$ alkyl group;
m may be an integer from 1 to 10;

For example, each of $R_5$ and $R_6$ may be hydrogen. i) X and Y may each be $CH_2$ or ii) X may be $CH_2$, and Y may be O. m may be an integer from 3 to 6.
According to one or more embodiments, the cross-linking agent may be 1,6-hexanediol diacrylate or polyethylene glycol) diacrylate.
According to one or more embodiments, the second adhesive film may further comprise the cross-linking agent, and the amount of the cross-linking agent may be about 0.01 parts by weight to about 0.5 parts by weight based on 100 parts by weight of the acrylic polymer.
According to one or more embodiments, the photoinitiator may be (1-hydroxycyclohexyl)(phenyl)methanone.
According to one or more embodiments, the second adhesive film may further comprise the photoinitiator, and the amount of the photoinitiator may be about 0.01 parts by weight to about 0.4 parts by weight based on 100 parts by weight of the acrylic polymer.
According to one or more embodiments, the molecular weight regulator may be n-dodecyl mercaptan.
According to one or more embodiments, the second adhesive film may further comprise the molecular weight regulator, and the amount of the molecular weight regulator may be about 0.01 parts by weight to about 0.2 parts by weight based on 100 parts by weight of the acrylic polymer.
According to one or more embodiments, the second adhesive film may be an optical clear adhesive (OCA). For example, the second adhesive film may be transparent.

**Electronic Device**

According to another aspect, provided is an electronic device comprising

a display panel comprising a light-emitting element,
a cover window provided on the display panel,
an adhesive film (e.g., the first adhesive film or the second adhesive film) provided between the display panel and the cover window; and
a color filter, a color conversion layer, a touch screen layer, a polarization layer, or a combination thereof.

According to one or more embodiments, the electronic device may further comprise the polarization layer provided between the display panel and the adhesive film (e.g., the first adhesive film or the second adhesive film), and the adhesive film (e.g., the first adhesive film or the second adhesive film) may be in a direct contact with the polarization layer.
According to one or more embodiments, the electronic device may further comprise a black matrix provided between the adhesive film (e.g., the first adhesive film or the second adhesive film) and the cover window, and the adhesive film (e.g., the first adhesive film or the second adhesive film) may cover at least a portion of the black matrix.
The adhesive film according to one or more embodiments may i) have excellent or suitable flexibility so as to cover the black matrix at a step, and ii) have excellent or suitable reliability so as not to generate bubbles in a high temperature/high humidity environment. In some embodiments, the adhesive film according to one or more embodiments may have appropriate or suitable flexibility so that the adhesive film and the black matrix are not separated from each other even when the crosslinking density is increased by irradiating ultraviolet rays to improve reliability.

**Electronic apparatus**

An electronic device comprising the adhesive film (e.g., the first adhesive film or the second adhesive film)

according to one or more embodiments may be included in one or more suitable electronic apparatuses.

For example, the electronic apparatus may comprise at least one selected from among of a flat panel display, a curved display, a computer monitor, a medical monitor, a television, a billboard, a light for indoor or outdoor lighting and/or signaling, a heads-up display, a fully or partially transparent display, a flexible display, a rollable display, a foldable display, a stretchable display, a laser printer, a phone, a cell phone, a tablet, a phablet, a personal digital assistant (PDA), a wearable device, a laptop computer, a digital camera, a camcorder, a viewfinder, a micro-display, a 3D display, a virtual reality or augmented reality display, a vehicle, a video wall comprising multiple displays tiled together, a theater or stadium screen, a phototherapy device, and a signage.

Because the adhesive film has excellent or suitable reliability and excellent or suitable flow characteristics in a high temperature environment and/or a high temperature and high humidity environment, the display quality of the electronic device comprising the adhesive film and the electronic apparatus comprising the adhesive film may be excellent or suitable. Accordingly, the adhesive film may be suitable for application to a display for a vehicle. However, the utilize of the adhesive film is not limited to a vehicle display.

## Description of FIG. 2

FIG. 2 shows a perspective view schematically illustrating an electronic apparatus 1 comprising an electronic device according to one or more embodiments. The electronic apparatus 1 is a device that displays moving images or still images, and may be a portable electronic apparatus such as a mobile phone, a smart phone, a tablet personal computer (PC), a mobile communication terminal, an electronic notebook, an electronic book, a portable multimedia player (PMP), a navigation system, and/or a ultra mobile PC (UMPC). In some embodiments, the electronic apparatus 1 may be a television, a laptop, a monitor, a billboards, an Internet of Things (IoT) device, and/or the like, or parts thereof. In some embodiments, the electronic apparatus 1 may be a wearable device such as a smart watch, a watch phone, a glasses-type or kind display, or a head mounted display (HMD) or a part thereof. However, the present disclosure is not limited thereto.

For example, the electronic apparatus 1 may comprise at least one selected from among a dashboard of a car, a center information display (CID) provided on a center fascia or dashboard of a car, a room mirror display replacing a side mirror of a car, a display placed on the rear seat entertainment or the rear side of the front seat of a car, a head-up display (HUD) installed in front of a vehicle or projected on the front window glass, and/or a computer-generated holographic augmented reality head-up display (CGH AR HUD). FIG. 2 illustrates a case where the electronic apparatus 1 is a smart phone, for convenience of description.

The electronic apparatus 1 may comprise a display area DA and a non-display area NDA outside the display area DA. The electronic apparatus 1 may implement an image through an array of a plurality of pixels two-dimensionally arranged in the display area DA.

The non-display area NDA is an area that does not display an image and may entirely surround the display area DA. A driver and/or the like may be provided in the non-display area NDA to provide electrical signals or power to the display elements provided in the display area DA. A pad may be provided in the non-display area NDA, wherein the pad is an area to which an electronic device or a printed circuit board may be electrically connected.

The electronic apparatus 1 may have different lengths in the x-axis direction and in the y-axis direction. For example, as shown in FIG. 2, the length in the x-axis direction may be shorter than the length in the y-axis direction. In some embodiments, the length in the x-axis direction and the length in the y-axis direction may be the same. In some embodiments, the length in the x-axis direction may be longer than the length in the y-axis direction.

## Description of FIGS. 3 and 4A to 4C

FIG. 3 is a diagram schematically showing the exterior of a vehicle 1000 as an electronic apparatus comprising an electronic device according to one or more embodiments. FIGS. 4A to 4C are diagrams schematically illustrating the interior of the vehicle 1000 according to one or more suitable embodiments of the present disclosure.

Referring to FIGS. 3, 4A, 4B, and 4C, the vehicle 1000 may refer to one or more suitable devices that move objects such as humans, objects, or animals from a starting point to a destination point. The vehicle 1000 may comprise a vehicle that travels on a road or a track, a ship that moves over the sea or river, and/or an airplane that flies in the sky utilizing the action of air.

The vehicle 1000 may be driven on a road or a track. The vehicle 1000 may move in a set or predetermined direction according to rotation of at least one wheel. For example, the vehicle 1000 may comprise a three- or four-wheeled vehicle, a construction machine, a two-wheeled vehicle, a motor vehicle, a bicycle, and/or a train running on a track.

The vehicle 1000 may comprise a body having interior and exterior parts, and a chassis which is the remainder except for the body and on which mechanical devices necessary for driving are installed. The exterior of the body may

comprise a pillar provided at boundaries of a front panel, a bonnet, a roof panel, a rear panel, a trunk, and/or a door. A chassis of the vehicle 1000 may comprise a power generating device, a power transmission device, a traveling device, a steering device, a braking device, a suspension device, a transmission device, a fuel device, front and rear wheels, and/or the like.

The vehicle 1000 may comprise a side window glass 1100, a front window glass 1200, a side mirror 1300, a cluster 1400, a center fascia 1500, a passenger seat dashboard 1600, and/or a display device 2.

The side window glass 1100 and the front window glass 1200 may be partitioned by a pillar provided between the side window glass 1100 and the front window glass 1200.

The side window glass 1100 may be installed on the side of the vehicle 1000. In an implementation, the side window glass 1100 may be installed on a door of the vehicle 1000. The side window glass 1100 may comprise a plurality of side window glasses which may face each other. In one or more embodiments, the side window glass 1100 may comprise a first side window glass 1110 and a second side window glass 1120. In one or more embodiments, the first side window glass 1110 may be provided adjacent to the cluster 1400. The second side window glass 1120 may be provided adjacent to the passenger seat dashboard 1600.

In one or more embodiments, the side window glasses 1100 may be spaced and/or apart from each other in the x direction or the -x direction. For example, the first side window glass 1110 and the second side window glass 1120 may be spaced and/or apart from each other in the x direction or the -x direction. In other words, the imaginary straight line L connecting the side window glasses 1100 may extend in the x direction or the -x direction. For example, the imaginary straight line L connecting the first side window glass 1110 and the second side window glass 1120 to each other may extend in the x direction or the -x direction.

The front window glass 1200 may be installed in front of the vehicle 1000. The front window glass 1200 may be provided between the side window glasses 1100 facing each other.

The side mirror 1300 may provide a rear view of the vehicle 1000. The side mirror 1300 may be installed on the exterior of a body. In one or more embodiments, the side mirror 1300 may comprise a plurality of side mirrors. Any one of the plurality of side mirrors 1300 may be provided outside the first side window glass 1110. Another one of the plurality of side mirrors 1300 may be provided outside the second side window glass 1120.

The cluster 1400 may be located in front of the steering wheel. The cluster 1400 may comprise a tachometer, a speedometer, a coolant thermometer, a fuel gauge turn indicator, a high beam indicator, a warning lamp, a seat belt warning lamp, an odometer, a hodometer, an automatic shift selector indicator lamp, a door open warning lamp, an engine oil warning lamp, and/or a low fuel warning light.

The center fascia 1500 may comprise a control panel on which a plurality of buttons for adjusting an audio device, an air conditioning device, and a heater of a seat are provided. The center fascia 1500 may be arranged on one side of the cluster 1400.

A passenger seat dashboard 1600 may be spaced and/or apart from the cluster 1400 with the center fascia 1500 arranged therebetween. In one or more embodiments, the cluster 1400 may be arranged to correspond to a driver seat, and the passenger seat dashboard 1600 may be provided to correspond to a passenger seat. In one or more embodiments, the cluster 1400 may be adjacent to the first side window glass 1110, and the passenger seat dashboard 1600 may be adjacent to the second side window glass 1120.

In one or more embodiments, the display device 2 may comprise a display panel 3, and the display panel 3 may display an image. The display device 2 may be arranged inside the vehicle 1000. In one or more embodiments, the display device 2 may be provided between side window glasses 1100 facing each other. The display device 2 may be arranged on at least one of the cluster 1400, the center fascia 1500, and the passenger seat dashboard 1600.

The display device 2 may comprise an organic light-emitting display, an inorganic light-emitting display, a quantum dot display, and/or the like.

Referring to FIG. 4A, the display device 2 may be provided on the center fascia 1500. In one or more embodiments, the display device 2 may display navigation information. In one or more embodiments, the display device 2 may display audio, video, or information regarding vehicle settings.

Referring to FIG. 4B, the display device 2 may be provided in a cluster 1400. When the display device 2 is arranged on the cluster 1400, the cluster 1400 may display driving information and/or the like through the display device 2. For example, the cluster 1400 may be implemented digitally. The digital cluster 1400 may display vehicle information and driving information as images. For example, a needle and a gauge of a tachometer and one or more suitable warning light icons may be displayed by a digital signal.

Referring to FIG. 4C, the display device 2 may be provided on the passenger seat dashboard 1600. The display device 2 may be embedded in the passenger seat dashboard 1600 or arranged on the passenger seat dashboard 1600. In one or more embodiments, the display device 2 arranged on the passenger seat dashboard 1600 may display an image related to information displayed on the cluster 1400 and/or information displayed on the center fascia 1500. In one or more embodiments, the display device 2 arranged on the passenger seat dashboard 1600 may display information different from information displayed on the cluster 1400 and/or information displayed on the center fascia 1500.

Terms such as "substantially," "about," and "approximately" are used as relative terms and not as terms of degree, and are intended to account for the inherent deviations in measured or calculated values that would be recognized by those of ordinary skill in the art. They may be inclusive of the stated value and an acceptable range of deviation as determined by one of ordinary skill in the art, considering the limitations and error associated with measurement of that quantity. For example, "about" may refer to one or more standard deviations, or ± 30%, 20%, 10%, 5% of the stated value.

Numerical ranges disclosed herein comprise and are intended to disclose all subsumed subranges of the same numerical precision. For example, a range of "1.0 to 10.0" comprises all subranges having a minimum value equal to or greater than 1.0 and a maximum value equal to or less than 10.0, such as, for example, 2.4 to 7.6. Applicant therefore reserves the right to amend this specification, comprising the claims, to expressly recite any sub-range subsumed within the ranges expressly recited herein.

The electronic device (e.g., display device), light-emitting element, and/or any other relevant devices or components according to embodiments of the present disclosure described herein may be implemented utilizing any suitable hardware, firmware (e.g., an application-specific integrated circuit), software, or a combination of software, firmware, and hardware. For example, the various components of the electronic device and/or light-emitting element may be formed on one integrated circuit (IC) chip or on separate IC chips. Further, the various components of the electronic device and/or light-emitting element may be implemented on a flexible printed circuit film, a tape carrier package (TCP), a printed circuit board (PCB), or formed on one substrate. Further, the various components of the electronic device and/or light-emitting element may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

Hereinafter, with reference to examples, an adhesive film and an electronic device according to one or more embodiments will be described in more detail. The examples described are only illustrations to assist the understanding of the present disclosure, and the scope of the present disclosure is not limited thereto.

## EXAMPLES

### Synthesis Example 1

2-ethylhexyl acrylate and 2-hydroxyethyl acrylate, which are monomers, 1,6-hexanediol diacrylate, which is a cross-linking agent, (1-hydroxycyclohexyl)(phenyl)methanone, which is a photoinitiator, and n-dodecyl mercaptan, which is a molecular weight regulator, were mixed to synthesize Polymer A having a weight average molecular weight of 110,000. Polymer A was first cured to prepare Adhesive Film 1.

### Synthesis Example 2

2-ethylhexyl acrylate and 2-hydroxyethyl acrylate, which are monomers, 1,6-hexanediol diacrylate, which is a cross-linking agent, (1-hydroxycyclohexyl)(phenyl)methanone, which is a photoinitiator, and n-dodecyl mercaptan, which is a molecular weight regulator, were mixed to synthesize Polymer B having a weight average molecular weight of 250,000. 70 parts by weight of the polymer A and 30 parts by weight of the polymer B were mixed and first cured to prepare Adhesive Film 2.

### Synthesis Example 3

2-ethylhexyl acrylate and 2-hydroxyethyl acrylate, which are monomers, 1,6-hexanediol diacrylate, which is a cross-linking agent, (1-hydroxycyclohexyl)(phenyl)methanone, which is a photoinitiator, and n-dodecyl mercaptan, which is a molecular weight regulator, were mixed to synthesize Polymer C having a weight average molecular weight of 530,000. 70 parts by weight of the polymer A and 30 parts by weight of the polymer C were mixed and first cured to prepare Adhesive Film 3.

### Synthesis Example 4

2-ethylhexyl acrylate and 2-hydroxyethyl acrylate, which are monomers, 1,6-hexanediol diacrylate, which is a

cross-linking agent, (1-hydroxycyclohexyl)(phenyl)methanone, which is a photoinitiator, and n-dodecyl mercaptan, which is a molecular weight regulator, were mixed to synthesize Polymer D having a weight average molecular weight of 700,000. 70 parts by weight of the polymer A and 30 parts by weight of the polymer D were mixed and first cured to prepare Adhesive Film 4.

**Synthesis Example 5**

2-ethylhexyl acrylate and 2-hydroxyethyl acrylate, which are monomers, 1,6-hexanediol diacrylate, which is a cross-linking agent, (1-hydroxycyclohexyl)(phenyl)methanone, which is a photoinitiator, and n-dodecyl mercaptan, which is a molecular weight regulator, were mixed to synthesize Polymer E having a weight average molecular weight of 1 ,000,000. 70 parts by weight of the polymer A and 30 parts by weight of the polymer E were mixed and first cured to prepare Adhesive Film 5.

**Synthesis Example 11**

Polymer A according to Synthesis Example 1 was irradiated (e.g., first cured) with ultraviolet rays (UV) of 1000 mJ utilizing a low-pressure lamp to synthesize Polymer 11, which is more crosslinked than Polymer A. Polymer 11 was cured (e.g., second cured) to prepare Adhesive Film 11.

**Synthesis Example 12**

Polymer A according to Synthesis Example 1 was irradiated (e.g., first cured) with ultraviolet rays (UV) of 1500 mJ utilizing a low-pressure lamp to synthesize Polymer 12, which is more crosslinked than Polymer A. Polymer 12 was cured (e.g., second cured) to prepare Adhesive Film 12.

**Synthesis Example 13**

Polymer 13 more crosslinked than Polymer A was synthesized by irradiating (e.g., first curing) 500 mJ of ultraviolet (UV) to Polymer A according to Synthesis Example 1 utilizing a highpressure lamp. Polymer 13 was cured (e.g., second cured) to prepare Adhesive Film 13.

**Synthesis Example 14**

Polymer 14, which is more crosslinked than Polymer A, was synthesized by irradiating (e.g., first curing) 700 mJ of ultraviolet (UV) to Polymer A according to Synthesis Example 1 utilizing a highpressure lamp. The adhesive film 14 was prepared by curing (e.g., second curing) the polymer 14.

**Synthesis Example 15**

Polymer 15, which is more crosslinked than Polymer A, was synthesized by irradiating (e.g., first curing) 1000 mJ of ultraviolet (UV) to Polymer A according to Synthesis Example 1 utilizing a highpressure lamp. Polymer 15 was cured (e.g., second cured) to prepare Adhesive Film 15.

**Synthesis Example 16**

Polymer 16, which is more crosslinked than Polymer A, was synthesized by irradiating (e.g., first curing) 1500 mJ of ultraviolet (UV) to Polymer A according to Synthesis Example 1 utilizing a highpressure lamp. Polymer 16 was cured (e.g., second cured) to prepare Adhesive Film 16.

**Evaluation Example 1 modulus, creep and degree of stress relaxation**

Modulus, creep, and degree of stress relaxation of each of the Adhesive Films 1 to 5 and 11 to 16 were evaluated according to the method described in Table 1.

In order to compare the results according to the weight average molecular weight, the results of Adhesive Films 1 to 5 are shown in Table 2.

In order to compare the results according to the crosslinking density, the results of Adhesive Films 1 and 11 to 16 are shown in Table 3.

Table 1

| | |
|---|---|
| Modulus | Modulus was measured utilizing an 8 mm stainless steel Jig (ARES facility of TA company). For example, measurements were made under the conditions of the frequency of 1 Hz, the axial force of 0.5 N, and the sensitivity of 0.2 N. |
| Creep | The creep value was measured utilizing ARES facility of TA company. For example, the stress of 1000 Pa was applied constantly at 70 °C to measure the strain (%) value after 175 seconds. When measured utilizing a DHR facility, the torque value is measured as 100 μN·m.<br>The recovery value can be calculated by measuring the strain (%) value 175 seconds after the stress of 0 Pa is applied after creep measurement. |
| Degree of stress relaxation | The degree of stress relaxation was measured utilizing an 8 mm stainless steel Jig (ARES facility of TA company). For example, the degree of stress relaxation was calculated according to Equation 1:<br>Equation 1<br>$SR = ST_{300}/ST_{0.01}$<br>wherein, in Equation 1,<br>SR is the degree of stress relaxation, $ST_{300}$ is the value of stress when 25% strain is applied at 70°C for 300 seconds, $ST_{0.01}$ is the value of stress when 25% strain is applied at 70°C for 0.01 seconds. |

Table 2 (First Cured, first adhesive films)

| | | Adhesive Film 1 | Adhesive Film 2 | Adhesive Film 3 | Adhesive Film 4 | Adhesive Film 5 |
|---|---|---|---|---|---|---|
| A polymer blended with a polymer having a weight average molecular weight of 110,000 (Weight average molecular weight) | | Polymer A (110,000) | Polymer B (250,000) | Polymer C (530,000) | Polymer D (700,000) | Polymer E (1,000,000) |
| Modulus (MPa) | 25°C | 0.181 | 0.182 | 0.061 | 0.146 | 0.193 |
| | 50°C | 0.042 | 0.056 | 0.026 | 0.040 | 0.050 |
| | 85°C | 0.009 | 0.019 | 0.010 | 0.008 | 0.012 |
| Creep (%) | 50°C | 41.8 | 18.4 | 64.3 | 37.8 | 34.3 |
| Degree of stress relaxation | 70°C | 0.038 | 0.11 | 0.03 | 0.03 | 0.05 |

From Table 2, it is confirmed that the creep value is maintained at an appropriate or suitable level, e.g., even when the weight average molecular weight of the polymer is increased. For example, Adhesive Films 1 to 5 each have such a creep value that is large enough to cover the black matrix at steps. In some embodiments, from Adhesive Films 1 to 5, the reliability of the adhesive film according to the weight average molecular weight of the polymer is confirmed to be comparable even when it has a relatively low crosslinking density (e.g., degree of stress relaxation).

Table 3 second cured, second adhesive films

| | | Adhesive Film 1 | Adhesive Film 11 | Adhesive Film 12 | Adhesive Film 13 | Adhesive Film 14 | Adhesive Film 15 | Adhesive Film 16 |
|---|---|---|---|---|---|---|---|---|
| UV-rays (pressure/energy) | | - | low pressure/ 1000 mJ | low pressure/ 1500 mJ | high pressure/ 500 mJ | high pressure/ 700 mJ | high pressure/ 1000 mJ | high pressure/ 1500 mJ |
| modulus (MPa) | 25°C | 0.181 | 0.205 | 0.211 | 0.183 | 0.189 | 0.199 | 0.201 |
| | 50°C | 0.042 | 0.055 | 0.056 | 0.052 | 0.053 | 0.053 | 0.055 |
| | 85°C | 0.009 | 0.015 | 0.017 | 0.017 | 0.018 | 0.017 | 0.019 |
| Creep (%) | 50°C | 41.8 | 30.7 | 22.5 | 17.4 | 15.7 | 11.2 | 10.1 |
| Degree of stress relaxation | 70°C | 0.038 | 0.067 | 0.095 | 0.154 | 0.169 | 0.206 | 0.250 |

In order to prepare the UV cured optical clear adhesive (OCA) (e.g., the twice UV cured), Adhesive Film 1 was further (e.g., again) irradiated with UV (second curing) according to Synthesis Examples 11 to 16. This is equivalent to (e.g., the same as) increasing the amount of UV light by sufficiently proceeding with the first UV curing that proceeds during the manufacture of the adhesive film.

From Table 3, it is confirmed that the crosslinking density of Adhesive Film 1, which is a UV curable OCA, is different from the crosslinking density of Adhesive Films 11 to 16 which are UV cured (twice-cured) OCA. As the crosslinking density is increased, the creep value is decreased. For example, it can be seen that as the crosslinking density is increased and the degree of stress relaxation is increased, the creep value is decreased and the flexibility of the adhesive film is decreased. However, it is confirmed that Adhesive Films 15 and 16 have an appropriate or suitable creep value (about 10% or more), that is large enough to cover the black matrix at steps while having excellent or suitable crosslinking density.

**Evaluation Example 2 Adhesive strength**

A polarization layer was attached to a glass substrate. Using a roller of 2 kgf, a thin film for each of Adhesive Films 1 to 5 and 11 to 16 was removed. Each of Adhesive Films 1 to 5 and 11 to 16 was attached to the polarization layer and allowed to stand at room temperature for 24 hours. Using Universal Testing Systems (manufactured by Instron company), after leaving them for 30 minutes in a chamber of high temperature/high humidity (85 °C /85% RH), the adhesive strength was measured at the angle of 180 ° and at the speed of 300 mm/s in an environment of high temperature/high humidity in a chamber. The adhesive strength was measured twice, and the average value was calculated.

In order to compare the adhesive strength according to the weight average molecular weight, the results of Adhesive Films 1 to 5 are shown in Table 4 and FIG. 5.

In order to compare the adhesive strength according to the crosslinking density, the results of Adhesive Films 1 and 11 to 16 are shown in Table 5 and FIG. 6.

Table 4

| | | Adhesive Film 1 | Adhesive Film 2 | Adhesive Film 3 | Adhesive Film 4 | Adhesive Film 5 |
|---|---|---|---|---|---|---|
| A polymer blended with a polymer having a weight average molecular weight of 110,000 (Weight average molecular weight) | | Polymer A (110,000) | Polymer B (250,000) | Polymer C (530,000) | Polymer D (700,000) | Polymer E (1,000,000) |
| Adhesive strength (gf/28 mm) | Once | 360 | 414 | 334 | 1247 | 798 |
| | Twice | 369 | 486 | 342 | 1270 | 1075 |
| | Average | 364.5 | 450 | 338 | 1258.5 | 936.5 |

From Table 4 and FIG. 5, it is confirmed that as the weight average molecular weight of the polymer increases, the adhesive strength is increased. Therefore, when a polymer having a high weight average molecular weight is utilized, adhesive strength may be excellent or suitable in a high-temperature, high-humidity environment.

Table 5

| | | Adhesive Film 1 | Adhesive Film 11 | Adhesive Film 12 | Adhesive Film 13 |
|---|---|---|---|---|---|
| Degree of stress relaxation | | 0.038 | 0.067 | 0.095 | 0.154 |
| Adhesive strength (gf/ 28 mm) | Once | 360 | 383 | 421 | 410 |
| | Twice | 369 | 370 | 386 | 393 |
| | Average | 364.5 | 376.5 | 403.5 | 401.5 |
| | | Adhesive Film 14 | Adhesive Film 15 | Adhesive Film 16 | |
| Degree of stress relaxation | | 0.169 | 0.206 | 0.250 | |
| Adhesive strength (gf/ 28 mm) | Once | 368 | 396 | 322 | |
| | Twice | 379 | 379 | 325 | |
| | Average | 373.5 | 387.5 | 323.5 | |

From Table 5 and FIG. 6, it can be seen that even when the crosslinking density is increased, the adhesive strength is substantially the same. Therefore, even when a polymer having a high crosslinking density is utilized, the adhesive strength may not be negatively affected (e.g., decreased).

**Evaluation Example 3 Reliability**

Each of Adhesive Films 1 to 5 and 11 to 16 was placed between the display panel and the cover window to manufacture each electronic device.

Each electronic device was placed at high temperature/high humidity (85 °C/85% RH) for 120 hours, and the formation of bubbles was confirmed utilizing scanning acoustic microscopy (SAM). The medium utilized for the measurement was water, and the frequency utilized was 30 MHz.

In order to compare the occurrence of bubbles according to the weight average molecular weight, the SAM results of the electronic devices manufactured utilizing Adhesive Films 1 to 5 are shown in FIGS. 7A to 7E, respectively.

In order to compare the formation of bubbles according to the crosslinking density, the SAM results of the electronic devices manufactured utilizing Adhesive Films 1 and 11 to 16 are shown in FIGS. 7A and 8A to 8F, respectively.

Bubbles identified in FIGS. 7A to 7E and FIGS. 8A to 8F are indicated by arrows.

Referring to FIGS. 7A through 7E, it can be seen that as the weight average molecular weight of the polymer is increased, the number of bubbles is decreased. For example, when polymer C having a weight average molecular weight of 530,000 was utilized, the generation of bubbles was significantly reduced, and when polymer D or polymer E having a weight average molecular weight of 700,000 or more was utilized, no bubbles were generated. Therefore, as a polymer having a relatively large weight average molecular weight is utilized, the flow properties of the adhesive film can be suppressed or reduced (or prevented or reduced) in a high temperature environment and/or a high temperature and high humidity environment, and the polymer included in the adhesive film may be inhibited (or prevented or reduced) from being strained or delaminating from an object (e.g., subject) on which the polymer is attached.

Referring to FIGS. 8A to 8F, it can be seen that as the crosslinking density of the polymer is increased, the number of bubbles tends to decrease. For example, no bubbles were generated when a polymer having the degree of stress relaxation of about 0.20 or more was utilized. Thus, as the crosslinking density of the polymer is increased, the penetration of moisture into the adhesive film may be inhibited (or prevented or reduced) and the flow of the polymer contained in the adhesive film may be inhibited (or prevented or reduced).

By inhibiting the undesired flow properties of the polymer contained in the adhesive film in a high temperature environment and/or a high temperature and high humidity environment, the straining and/or delamination of the adhesive film may be inhibited or prevented or reduced. Therefore, the reliability of the optical properties and adhesive properties of the adhesive film may be improved.

It should be understood that embodiments described herein should be considered in a descriptive sense only and not for purposes of limitation. Descriptions of features or aspects within each embodiment should typically be

considered as available for other similar features or aspects in other embodiments. While one or more embodiments have been described with reference to the drawings, it will be understood by those of ordinary skill in the art that one or more suitable changes in form and details may be made therein without departing from the spirit and scope as defined by the following claims and equivalents thereof.

## Claims

1. An adhesive film,

   wherein the adhesive film is formed by first-curing a composition,
   wherein the composition comprises:

      a high-molecular-weight acrylic polymer having a first weight average molecular weight of 700,000 or more;
      a low-molecular-weight acrylic polymer having a second weight average molecular weight of at most 500,000; and
      a cross-linking agent, a photoinitiator, a molecular weight regulator, or a combination thereof,
      and
      wherein, based on 100 parts by weight, which is a sum of an amount of the high-molecular-weight acrylic polymer and an amount of the low-molecular-weight acrylic polymer, the amount of the high-molecular-weight acrylic polymer is 30 parts by weight or more.

2. The adhesive film of claim 1, wherein

   the adhesive film has a degree of stress relaxation calculated according to Equation 1 of about 0.01 to about 0.50,
   a creep at 50 °C of 4% or more, and
   a modulus at 25 °C of about 0.04 megapascal (MPa) to about 0.70 MPa:

   Equation 1

   $$SR = ST_{300}/ST_{0.01},$$

   and
   wherein, in Equation 1,
   SR is the degree of stress relaxation,
   $ST_{300}$ is a value of stress when a strain of 25% is applied for 300 seconds, and
   $ST_{0.01}$ is a value of stress when a strain of 25% is applied for 0.01 seconds;
   optionally, wherein each of $ST_{300}$ and $ST_{0.01}$ is measured at 70 °C.

3. The adhesive film of claim 1 or claim 2, wherein
   the first weight average molecular weight is about 700,000 to about 3,000,000; AND/OR the second weight average molecular weight is about 100,000 to about 300,000.

4. The adhesive film of any one of claims 1 to 3, wherein
   an adhesive strength of the adhesive film is 300 gram force per 28 millimeter (gf/28mm) or more.

5. The adhesive film of any one of claims 1 to 4, wherein

   a degree of stress relaxation of the adhesive film after second-curing the adhesive film is about 0.20 to about 0.70; AND/OR
   the adhesive film is an optical clear adhesive (OCA).

6. The adhesive film of any one of claims 1 to 5, wherein

   the high-molecular-weight acrylic polymer is a polymer of a first compound represented by Formula 1 and a second compound represented by Formula 2,
   the low-molecular-weight acrylic polymer is a polymer of the first compound represented by Formula 1 and the

second compound represented by Formula 2,
the first compound and the second compound are different from each other:

Formula 1

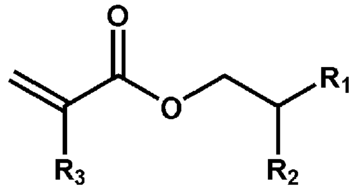

Formula 2

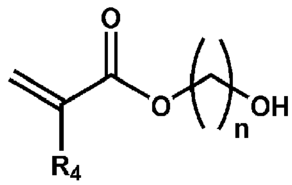

,

and
wherein, in Formulae 1 and 2,
$R_1$ to $R_4$ are each independently hydrogen, deuterium, a hydroxyl group, or a $C_1$-$C_{10}$ alkyl group, and
n is an integer from 1 to 10.

**7.** The adhesive film of any one of claims 1 to 6, wherein

the cross-linking agent is represented by Formula 3:

Formula 3

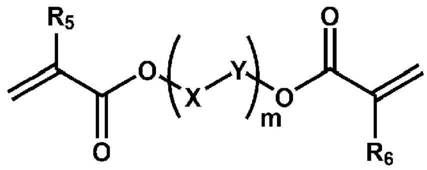

,

and
wherein, in Formula 3,
X and Y are each independently $CH_2$ or O,
$R_5$ and $R_6$ are each independently hydrogen, deuterium, a hydroxyl group, or a $C_1$-$C_{10}$ alkyl group, and
m is an integer from 1 to 10.

**8.** The adhesive film of any one of claims 1 to 7, wherein

the adhesive film further comprises the cross-linking agent, the photoinitiator, and the molecular weight regulator,
wherein, based on 100 parts by weight, which is the sum of the amount of the high-molecular-weight acrylic polymer and the amount of the low-molecular-weight acrylic polymer,
an amount of the cross-linking agent is about 0.01 parts by weight to about 0.5 parts by weight,
an amount of the photoinitiator is 0.01 parts by weight to 0.4 parts by weight, and
an amount of the molecular weight regulator is 0.01 parts by weight to 0.2 parts by weight.

**9.** An adhesive film,

wherein the adhesive film is formed by curing a composition, and
wherein the composition comprises:

an acrylic polymer; and
a cross-linking agent, a photoinitiator, a molecular weight regulator, or a combination thereof,

wherein the adhesive film has

a degree of stress relaxation calculated according to Equation 1 of about 0.20 to about 0.70,
a creep at 50 °C of 4% or more, and
a modulus at 25 °C of about 0.04 MPa to about 0.70 MPa:

Equation 1

$$SR = ST_{300}/ST_{0.01},$$

and

wherein, in Equation 1,
SR is the degree of stress relaxation,
$ST_{300}$ is a value of stress when a strain of 25% is applied for 300 seconds, and
$ST_{0.01}$ is a value of stress when a strain of 25% is applied for 0.01 seconds.

**10.** The adhesive film of claim 9, wherein

a weight average molecular weight of the acrylic polymer is about 100,000 to about 3,000,000;
AND/OR
an adhesive strength of the adhesive film is 300 gf/28mm or more.

**11.** The adhesive film of claim 9 or claim 10, wherein

the adhesive film is ultraviolet (UV) cured using a light amount of about 500 millijoule (mJ) to about 1500 mJ;
AND/OR
the adhesive film is transparent.

**12.** The adhesive film of any one of claims 9 to 11, wherein

the acrylic polymer is a polymer of a first compound represented by Formula 1 and a second compound represented by Formula 2, and
the first compound and the second compound are different from each other:

Formula 1

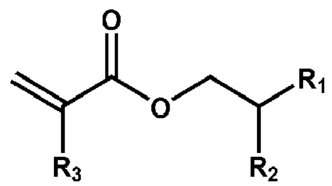

Formula 2

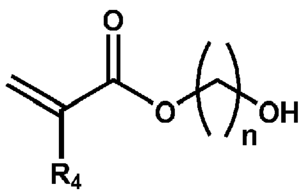

,

and
wherein, in Formulae 1 and 2,

$R_1$ to $R_4$ are each independently hydrogen, deuterium, a hydroxyl group, or a $C_1$-$C_{10}$ alkyl group, and
n is an integer from 1 to 10.

**13.** The adhesive film of claim 12, wherein,

based on 100 parts by weight of a total weight of the acrylic polymer,
an amount of the first compound is about 75 parts by weight to about 85 parts by weight, and
an amount of the second compound is about 15 parts by weight to about 25 parts by weight.

**14.** An electronic device comprising:

a display panel comprising a light-emitting element;
a cover window on the display panel;
the adhesive film according to any one of claims 1 to 13, between the display panel and the cover window; and
a color filter, a color conversion layer, a touch screen layer, a polarization layer, or a combination thereof.

**15.** A vehicle comprising

a body,
a chassis, and
an electronic device,
wherein
the electronic device comprises:

a display panel comprising a light-emitting element;
a cover window on the display panel; and
an adhesive film any one of claims 1 to 13 between the display panel and the cover window.

FIG. 1

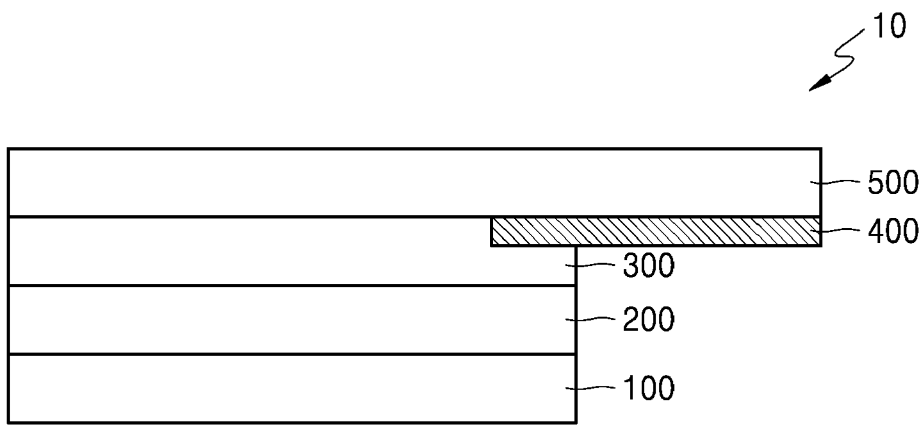

FIG. 2

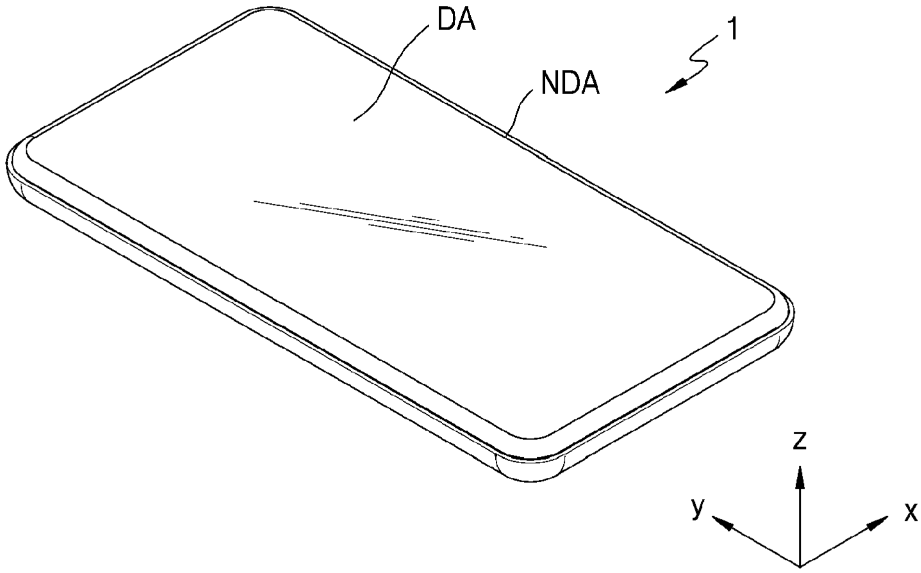


FIG. 3

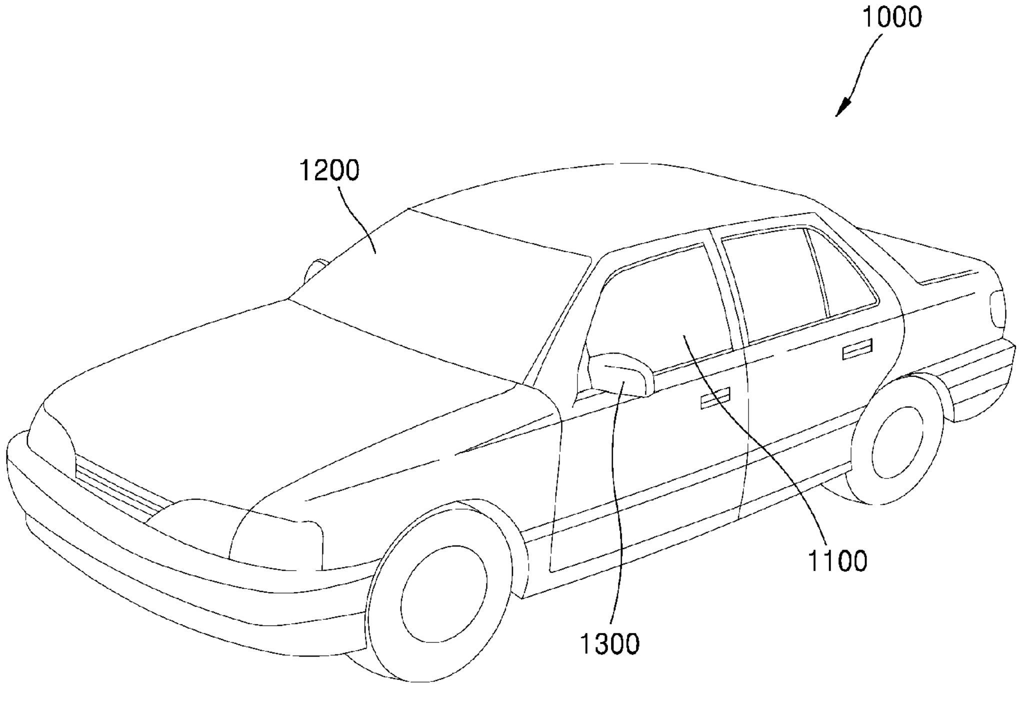

FIG. 4A

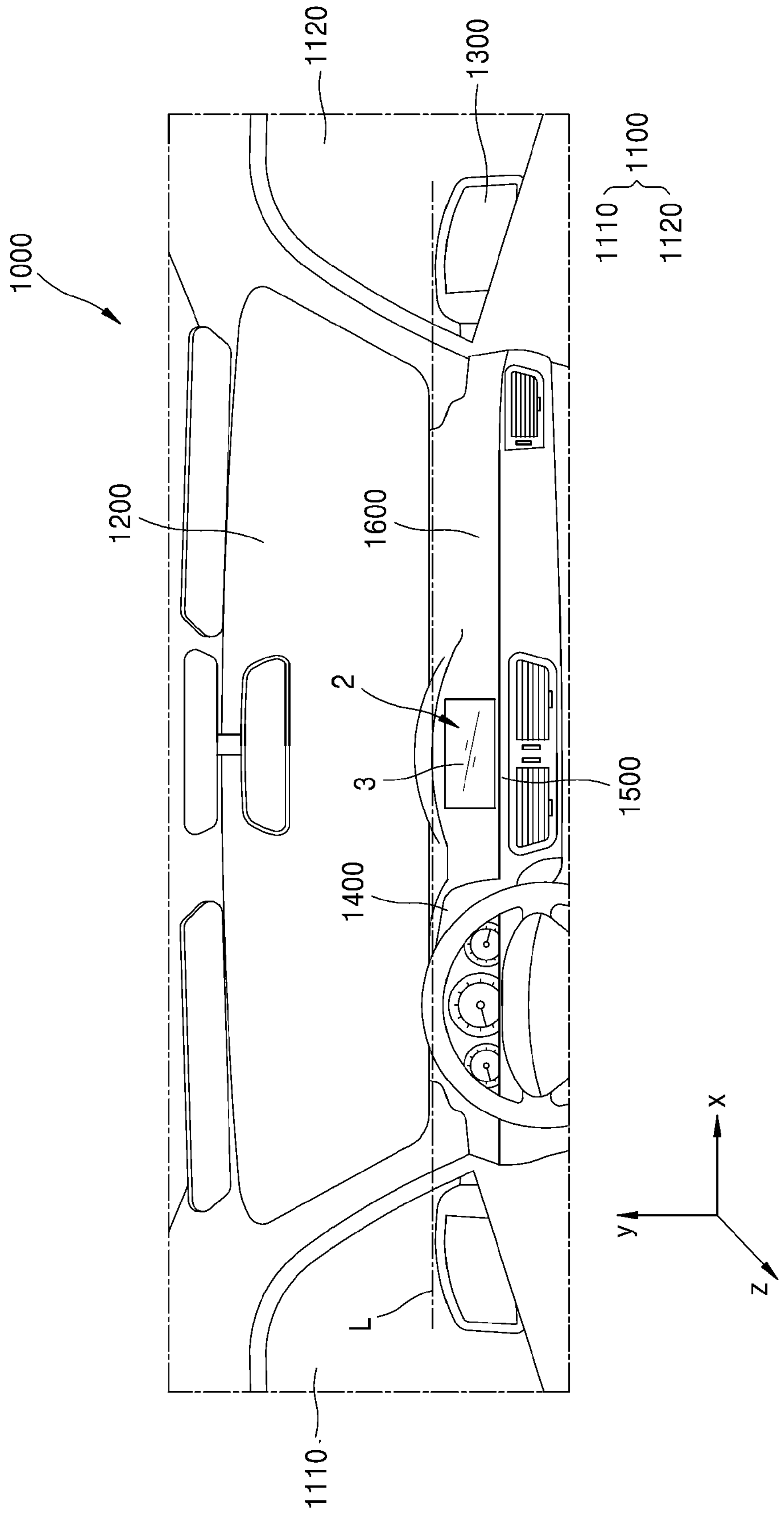
1000
1120
1300
1100
1110
1120
1200
1600
2
3
1500
1400
L
1110
x
y
z

FIG. 4B

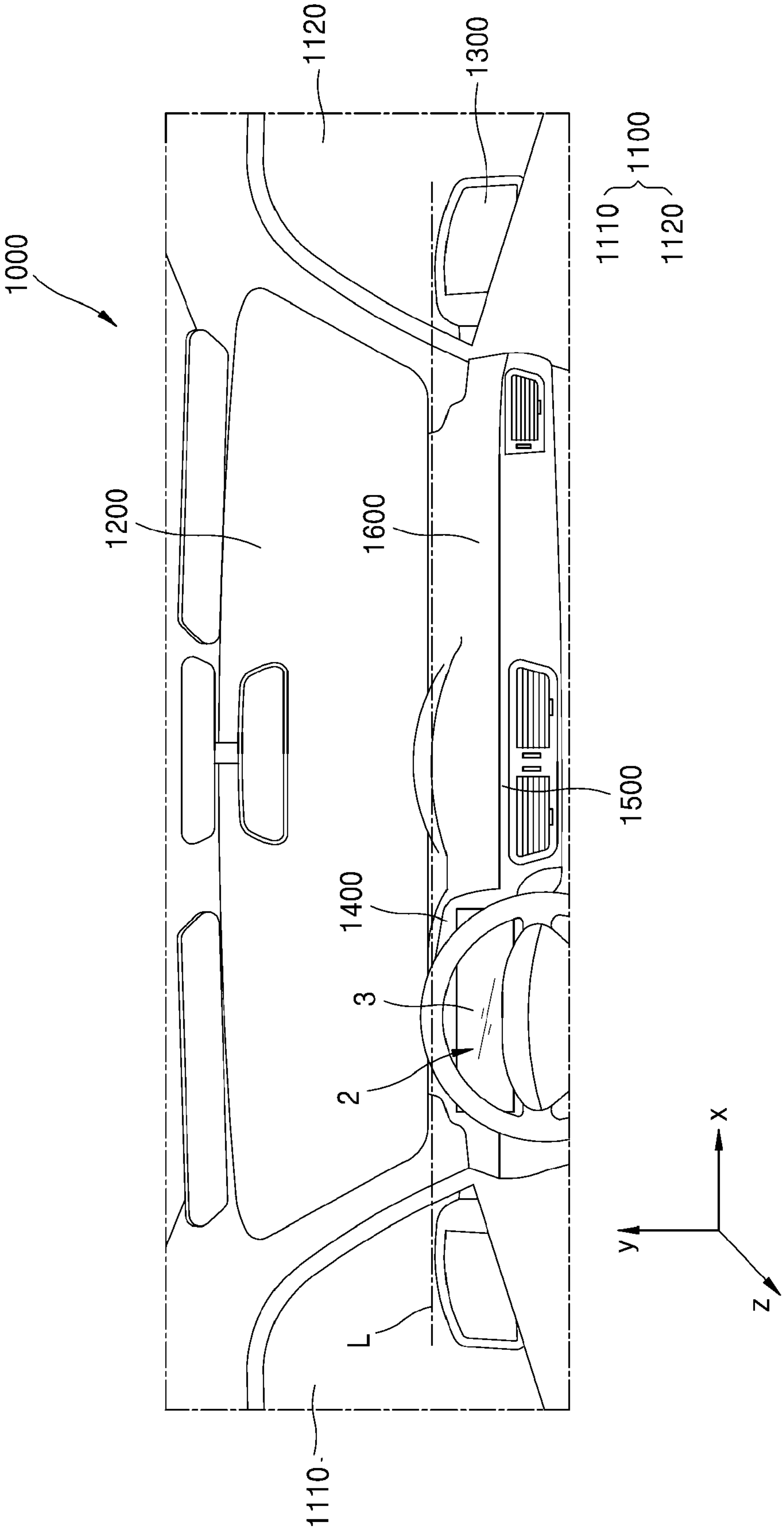
1000
1120
1300
1100
1110
1120
1200
1600
1500
1400
3
2
L
1110
x
y
z

FIG. 4C

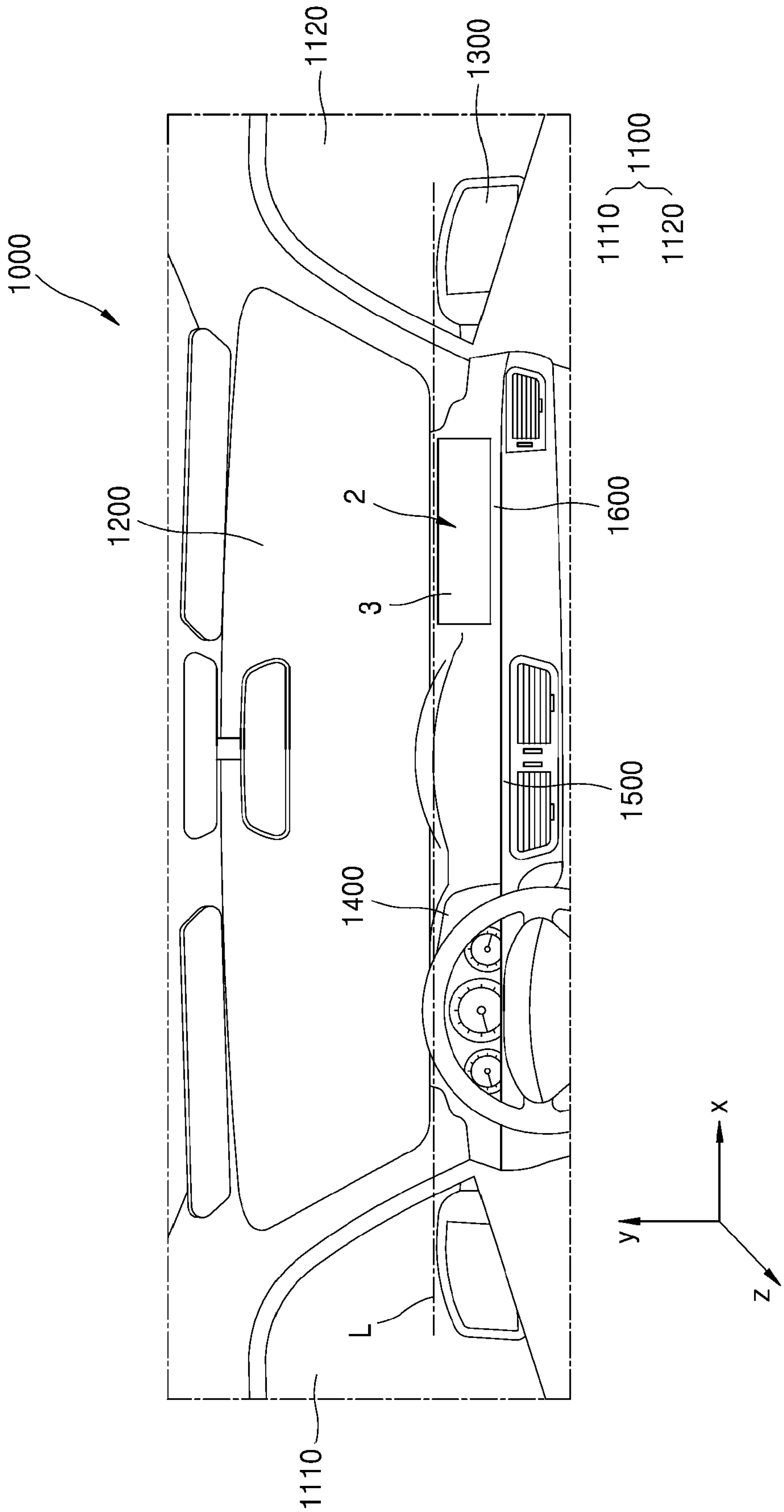
1000
1120
1300
1100
1110
1120
1200
2
3
1600
1500
1400
L
1110
x
y
z

FIG. 5

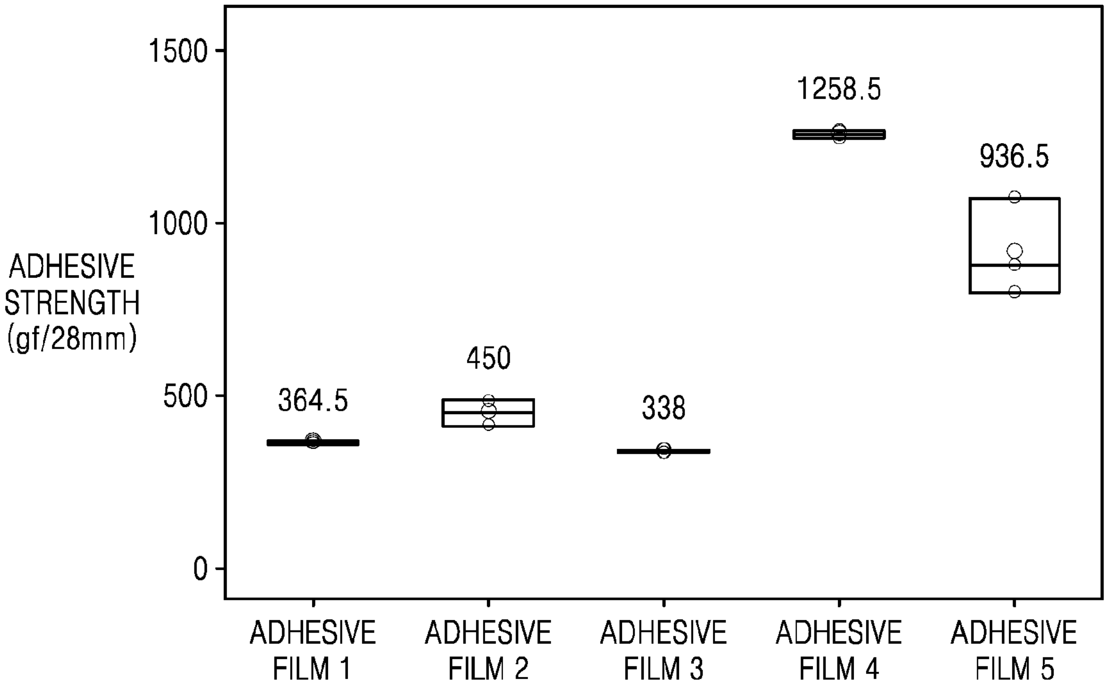
ADHESIVE STRENGTH (gf/28mm)
1500
1000
500
0
364.5
450
338
1258.5
936.5
ADHESIVE FILM 1
ADHESIVE FILM 2
ADHESIVE FILM 3
ADHESIVE FILM 4
ADHESIVE FILM 5

FIG. 6

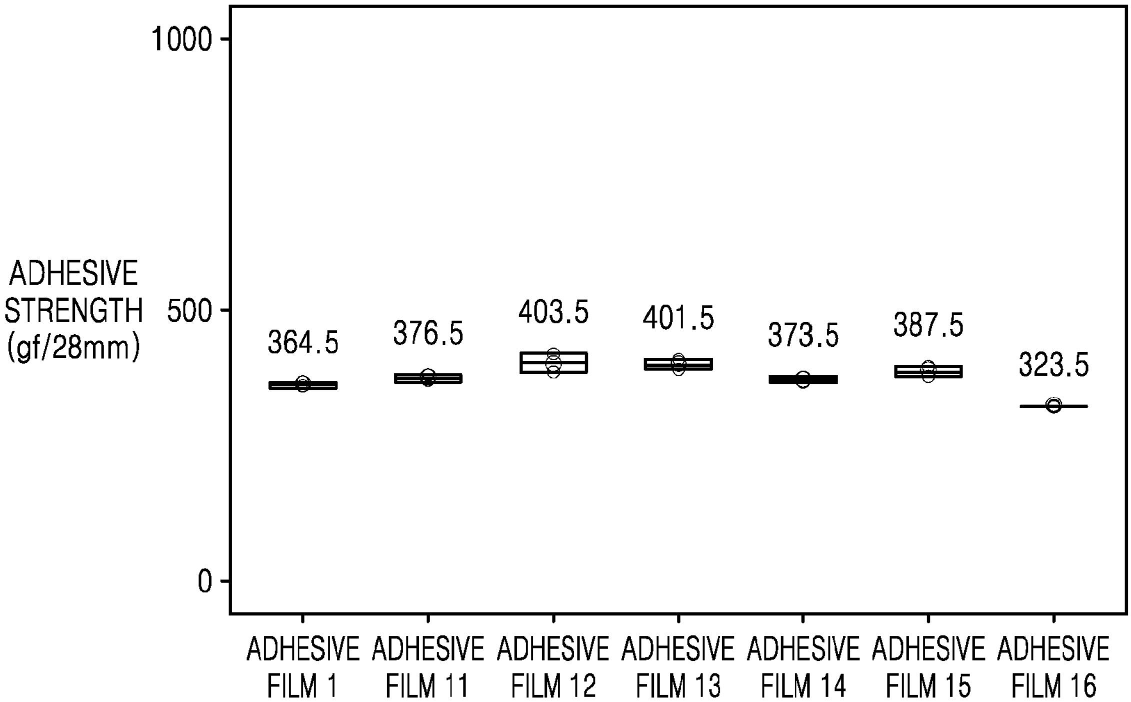
ADHESIVE STRENGTH (gf/28mm)
1000
500
0
364.5
376.5
403.5
401.5
373.5
387.5
323.5
ADHESIVE FILM 1
ADHESIVE FILM 11
ADHESIVE FILM 12
ADHESIVE FILM 13
ADHESIVE FILM 14
ADHESIVE FILM 15
ADHESIVE FILM 16

FIG. 7A

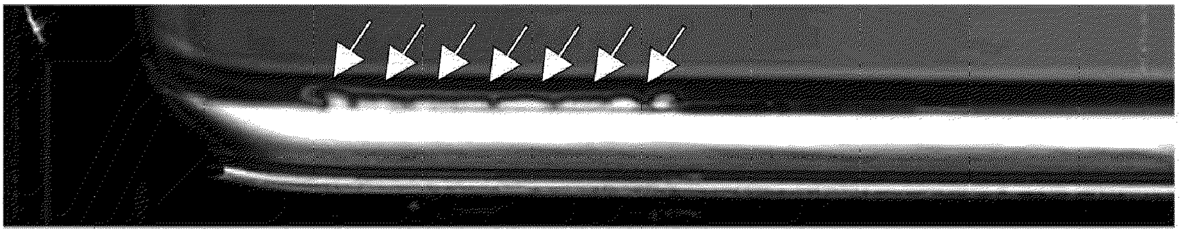

FIG. 7B

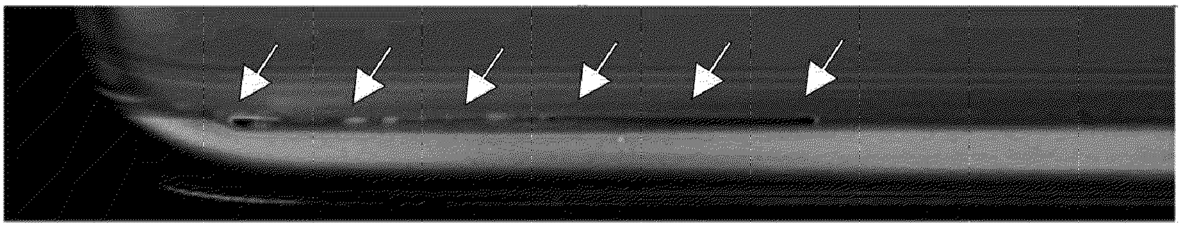

FIG. 7C

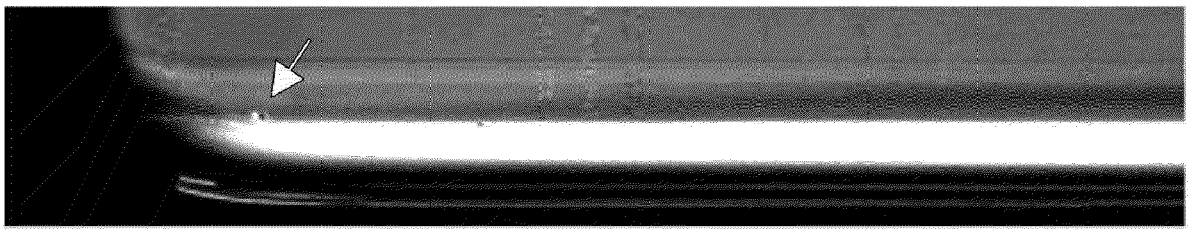

FIG. 7D

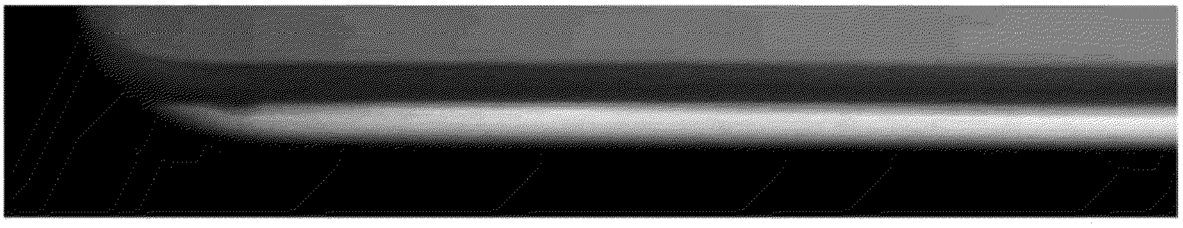

FIG. 7E

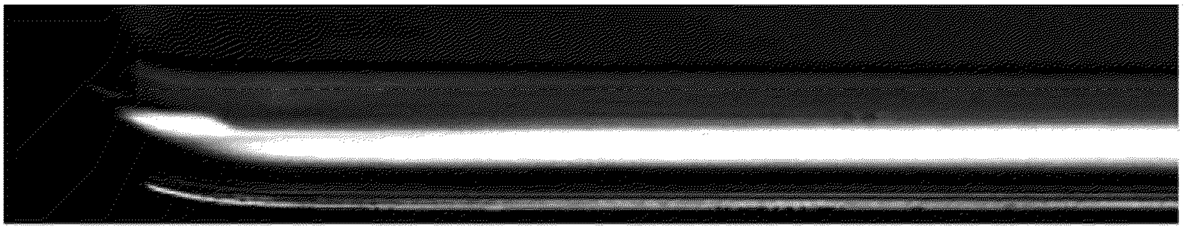

FIG. 8A

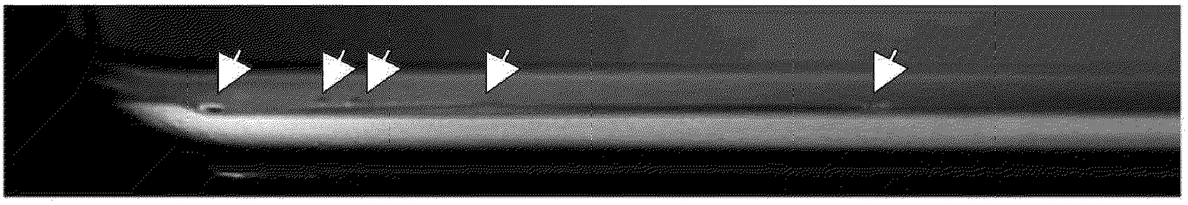

FIG. 8B

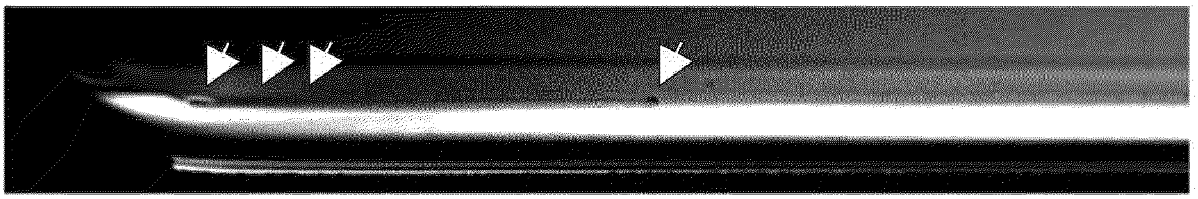

FIG. 8C

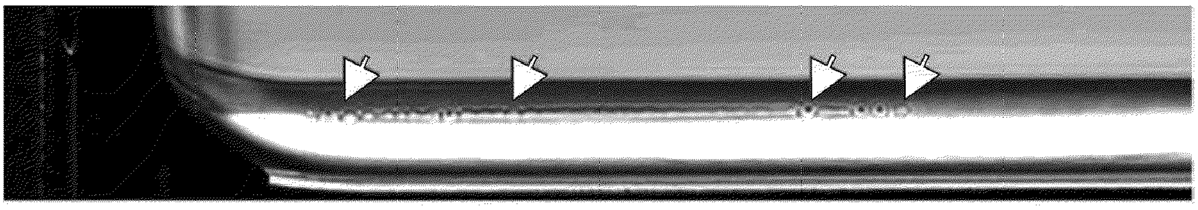

FIG. 8D

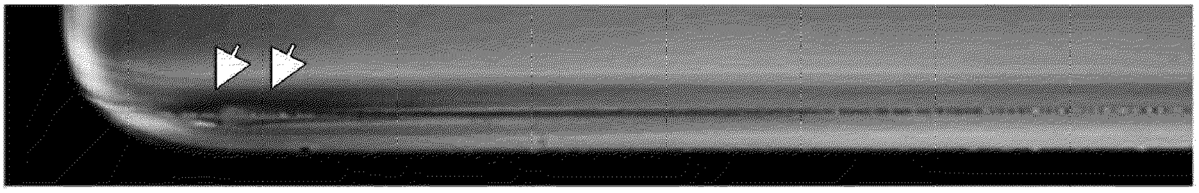

FIG. 8E

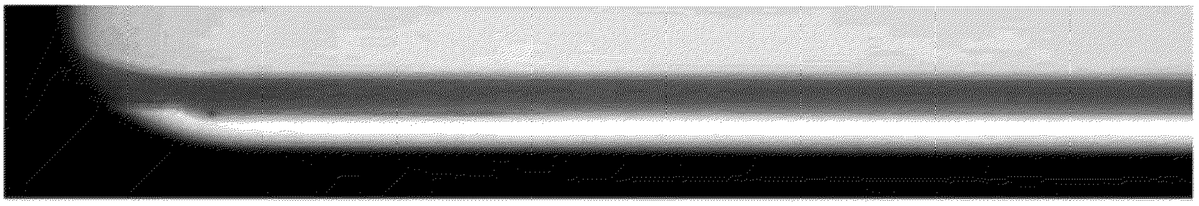

FIG. 8F

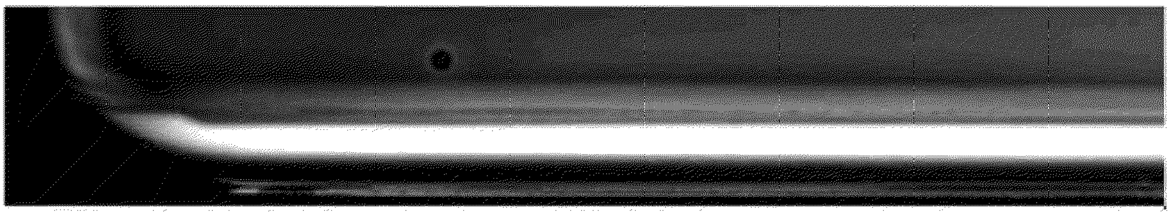

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020230039207
- KR 1020230094662